(19)

Europäisches Patentamt

European Patent Office

Office européen des brevets

(11) **EP 4 516 975 A1**

(12) **EUROPEAN PATENT APPLICATION**

published in accordance with Art. 153(4) EPC

(43) Date of publication:
**05.03.2025  Bulletin 2025/10**

(21) Application number: **22940146.8**

(22) Date of filing: **27.04.2022**

(51) International Patent Classification (IPC):
**C30B 29/40** (2006.01)      **C30B 29/42** (2006.01)

(52) Cooperative Patent Classification (CPC):
**C30B 29/40; C30B 29/42**

(86) International application number:
**PCT/JP2022/019084**

(87) International publication number:
**WO 2023/209867 (02.11.2023 Gazette 2023/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **SUMITOMO ELECTRIC INDUSTRIES,
LTD.
Osaka-shi, Osaka 541-0041 (JP)**

(72) Inventors:
• **SATANO, Masataka
  Kobe-shi, Hyogo 651-2271 (JP)**
• **KOUNOIKE, Kazuaki
  Kobe-shi, Hyogo 651-2271 (JP)**
• **YANAGISAWA, Takuya
  Kobe-shi, Hyogo 651-2271 (JP)**
• **HASHIO, Katsushi
  Kobe-shi, Hyogo 651-2271 (JP)**

(74) Representative: **Grünecker Patent- und
Rechtsanwälte
PartG mbB
Leopoldstraße 4
80802 München (DE)**

(54) **GROUP III-V COMPOUND SEMICONDUCTOR SINGLE CRYSTAL SUBSTRATE AND
MANUFACTURING METHOD THEREFOR**

(57)     This group III-V compound semiconductor single crystal substrate has a circular main surface, is an indium phosphide single crystal substrate, and has a ripple-like pattern visually recognized on the main surface by being subjected to the following treatment. The ripple-like pattern is a pattern corresponding to a part of ripples which concentrically spread from a wave source, and the wave source is not positioned on the main surface. The treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less.

FIG.1

EP 4 516 975 A1

**Description**

TECHNICAL FIELD

The present disclosure relates to a group III-V compound semiconductor single crystal substrate and a method for manufacturing the same.

BACKGROUND ART

Japanese Patent Laying-Open No. 2012-236770 (Patent Literature 1) and WO No. 2004/106597 (Patent Literature 2) disclose a group III-V compound semiconductor single crystal substrate such as an indium phosphide single crystal substrate. Japanese Patent Laying-Open No. 2019-043788 (Patent Literature 3) discloses a method for growing a compound semiconductor single crystal which becomes a raw material for a compound semiconductor single crystal substrate or the like, with the use of a so-called VB method such as a vertical Bridgman method. In general, the group III-V compound semiconductor single crystal substrate is manufactured by an operation of cutting out (hereinafter, the cutting out is also referred to as "slicing") a group III-V compound semiconductor single crystal such as an indium phosphide single crystal or a gallium arsenide single crystal into a disk shape.

CITATION LIST

PATENT LITERATURE

PTL 1: Japanese Patent Laying-Open No. 2012-236770
PTL 2: WO 2004/106597
PTL 3: Japanese Patent Laying-Open No. 2019-043788

SUMMARY OF INVENTION

The group III-V compound semiconductor single crystal substrate according to the present disclosure is a group III-V compound semiconductor single crystal substrate having a circular main surface, wherein the group III-V compound semiconductor single crystal substrate is an indium phosphide single crystal substrate; the indium phosphide single crystal substrate has a ripple-like pattern which is visually recognized on the main surface by being subjected to the following treatment; the ripple-like pattern is a pattern corresponding to a part of ripples which concentrically spread from a wave source; and the wave source is not positioned on the main surface, wherein the treatment horizontally arranges the main surface at a position of 10 mm below in a depth direction from a liquid level of a mixed liquid at 25°C, which contains 10 g of chromium(VI) oxide, 10 mL of hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less.

The group III-V compound semiconductor single crystal substrate according to the present disclosure is a group III-V compound semiconductor single crystal substrate having a circular main surface, wherein the group III-V compound semiconductor single crystal substrate is a gallium arsenide single crystal substrate; the gallium arsenide single crystal substrate has a ripple-like pattern which is visually recognized on the main surface by being subjected to the following treatment; the ripple-like pattern is a pattern corresponding to a part of ripples which concentrically spread from a wave source; and the wave source is not positioned on the main surface, wherein the treatment horizontally arranges the main surface at a position of 10 mm below in a depth direction from a liquid level of a mixed liquid at 25°C, which contains 10 g of chromium(VI) oxide, 10 mL of hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 5 minutes or more and 20 minutes or less.

A method for manufacturing a group III-V compound semiconductor single crystal substrate according to the present disclosure is a method for manufacturing a group III-V compound semiconductor single crystal substrate using a crystal growth apparatus, the method comprising: obtaining a group III-V compound semiconductor single crystal, by bringing a seed crystal into contact with a raw material melt, and growing a crystalline solid on the raw material melt side of the seed crystal; and obtaining the group III-V compound semiconductor single crystal substrate having a circular main surface, by cutting out the group III-V compound semiconductor single crystal, wherein the crystal growth apparatus comprises at least a cylindrical crucible, and a heating element that heats the crucible; the crucible houses the seed crystal at a bottom portion thereof, and houses the raw material melt above the seed crystal in the crucible; and an interface between the crystalline solid and the raw material melt has a crossing angle of less than 90° with respect to the axis of the crucible.

BRIEF DESCRIPTION OF DRAWINGS

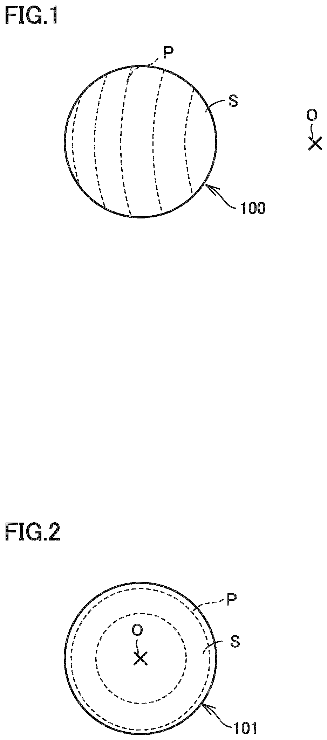

Fig. 1 is an illustrative diagram for describing a ripple-like pattern that is visually recognized on a main surface of a group III-V compound semiconductor single crystal substrate according to the present embodiment, by carrying out etching treatment with the use of light onto the main surface, and a wave source position of the ripple-like pattern.

Fig. 2 is an illustrative diagram for describing a ripple-like pattern that is visually recognized on a main surface of a conventional group III-V compound semiconductor single crystal substrate, by carrying out etching treatment with the use of light onto the main surface, and a wave source position of the ripple-like pattern.

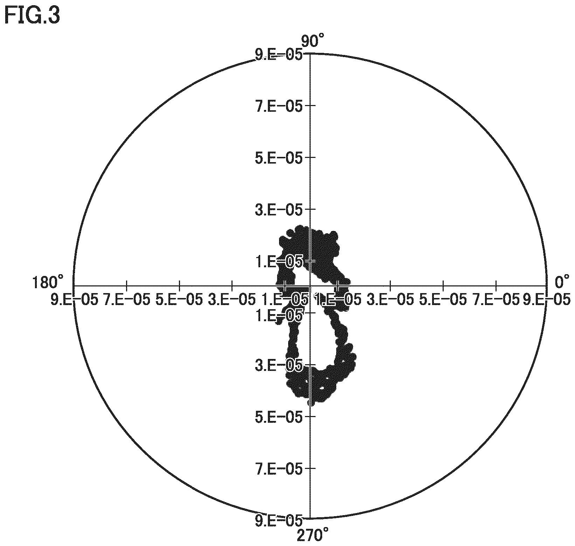

Fig. 3 is an illustrative diagram showing a residual strain which is an absolute value of a difference between a stretching strain in a direction along a diameter of a main surface and a stretching strain in a direction along a tangent line, regarding the group III-V compound semiconductor single crystal substrate according to the present embodiment, in a polar coordinate that sets the center of the main surface as an origin point, and regards the virtual line segment as the starting line, which extends from the center of the main surface to a point 15 mm away from the outer periphery of the group III-V compound semiconductor single crystal substrate, along a direction from the center of the main surface toward a wave source.

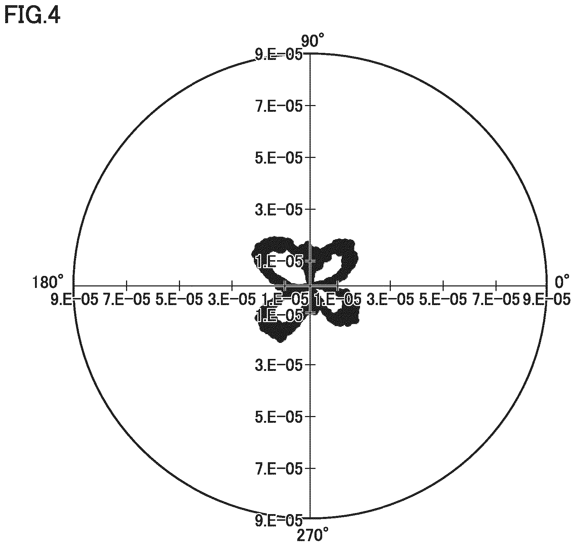

Fig. 4 is an illustrative diagram showing a residual strain which is an absolute value of a difference between a stretching strain in a direction along a diameter of a main surface and a stretching strain in a direction along a tangent line, regarding a conventional group III-V compound semiconductor single crystal substrate, in a polar coordinate that sets the center of the main surface as an origin point, and regards the virtual line segment as the starting line, which extends from the center of the main surface to a point 15 mm away from the outer periphery of the group III-V compound semiconductor single crystal substrate, along a direction from the center of the main surface toward a wave source.

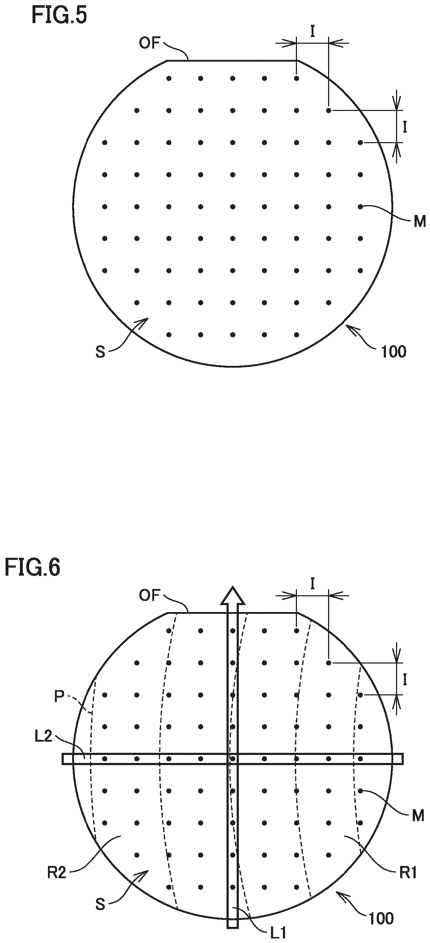

Fig. 5 is an illustrative diagram for describing measurement points at 69 points that are set on the main surface, for the purpose of obtaining a dislocation density of the main surface, regarding the group III-V compound semiconductor single crystal substrate according to the present embodiment.

Fig. 6 is an illustrative diagram for describing a method of obtaining a degree of asymmetry of dislocations existing on the main surface of the group III-V compound semiconductor single crystal substrate according to the present embodiment, by using the ripple-like pattern shown in Fig. 1 and the measurement points at 69 points shown in Fig. 5.

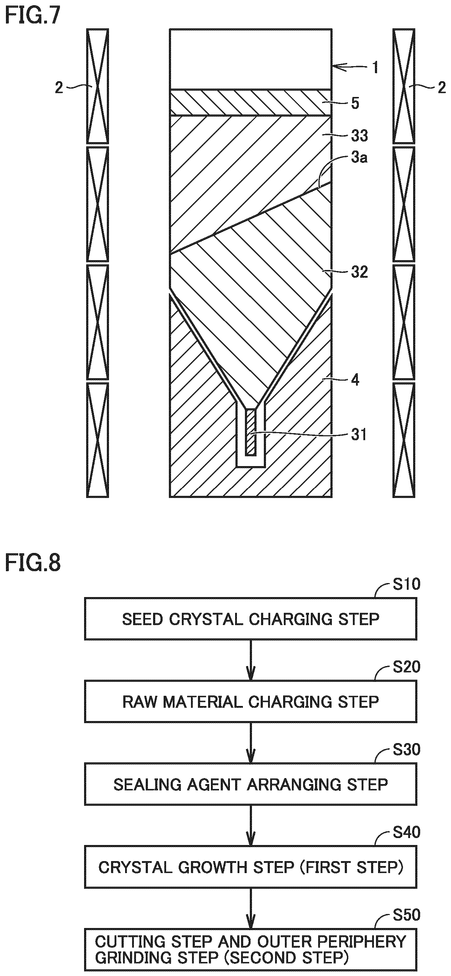

Fig. 7 is a schematic view for schematically describing a crystal growth apparatus for growing a group III-V compound semiconductor single crystal which becomes a raw material of the group III-V compound semiconductor single crystal substrate according to the present embodiment.

Fig. 8 is a flowchart showing one example of a method for manufacturing the group III-V compound semiconductor single crystal substrate according to the present embodiment.

DETAILED DESCRIPTION

[Problem to be Solved by the Present Disclosure]

In a process of obtaining a compound semiconductor single crystal substrate by slicing as disclosed in Patent Literatures 1 and 2, there has been a case where a stricter yield is required. Specifically, when a compound semiconductor single crystal is subjected to slicing, there is a case where so-called cracking defects occur in which cracking or chipping of the substrate occurs, and it has been demanded to decrease the probability of causing the cracking defects (hereinafter also referred to as "cracking defect rate"). In this case, there has been a room for improvement in the group III-V compound semiconductor single crystal substrate as disclosed in Patent Literatures 1 and 2, from the viewpoint of decreasing the cracking defect rate.

In view of the above circumstances, an object of the present disclosure is to provide a group III-V compound semiconductor single crystal substrate in which the cracking defect rate is decreased, and a method for manufacturing the same.

[Advantageous Effect of the Present Disclosure]

According to the present disclosure, it is possible to provide a group III-V compound semiconductor single crystal substrate in which the cracking defect rate is decreased, and a method for manufacturing the same.

[Outline of Embodiment]

First, an outline of an embodiment of the present disclosure will be described. The present inventors have carried out intensive studies to solve the above problems, and completed the present disclosure. Specifically, the present inventors have adopted the following method as a method for growing a group III-V compound semiconductor single crystal which becomes a raw material of the group III-V compound semiconductor single crystal substrate, in a crucible of a crystal growth apparatus, with the use of a so-called VB method such as a vertical boat method. Specifically, the present inventors set the interface between the crystalline solid to be grown on the side of the raw material melt of the seed crystal and the raw material melt so as not to be horizontal as in the conventional technique, but set so as to have a crossing angle of less than 90° with respect to the axis of the crucible. The present inventors have found that in the case where such a method has been used, the cracking defect rate is decreased at the time of obtaining the group III-V compound semiconductor single crystal substrate by slicing. Furthermore, the present inventors have found that wave source of the ripple-like pattern which is obtained by performing predetermined etching treatment onto the main surface of the group III-V compound semiconductor single crystal substrate that has been obtained by employing the above method is not positioned on the main surface unlike the conventional one, and have reached the present disclosure.

Next, embodiments of the present disclosure will be listed and described.

[1] A group III-V compound semiconductor single crystal substrate according to one aspect of the present disclosure is a group III-V compound semiconductor single crystal substrate having a circular main surface, wherein the group III-V compound semiconductor single crystal substrate is an indium phosphide single crystal substrate; the indium phosphide single crystal substrate has a ripple-like pattern that is visually recognized on the main surface by being subjected to the following treatment; the ripple-like pattern is a pattern corresponding to a part of ripples which concentrically spread from a wave source; and the wave source is not positioned on the main surface, wherein the treatment horizontally arranges the main surface at a position of 10 mm below in a depth direction from a liquid level of a mixed liquid at 25°C, which contains 10 g of chromium(VI) oxide, 10 mL of hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less.
The indium phosphide single crystal substrate which is the group III-V compound semiconductor single crystal substrate having such characteristics can decrease the cracking defect rate at the time of slicing.
[2] It is preferable that a diameter of the indium phosphide single crystal substrate is 50 mm or more and 155 mm or less. Thereby, it becomes possible to decrease the cracking defect rate at the time of slicing of the indium phosphide single crystal substrate having a diameter of 50 mm or more and 155 mm or less.
[3] It is preferable that a dislocation density of the main surface is 0 cm$^{-2}$ or more and 2000 cm$^{-2}$ or less. Thereby, it becomes possible to provide an indium phosphide single crystal substrate in which the dislocation density is further decreased over the whole surface of the main surface.
[4] It is preferable that a degree of asymmetry of dislocations existing in the main surface is 1.8 or more, where the degree of asymmetry is calculated by dividing the main surface into a first region and a second region by a virtual first straight line that intersects perpendicularly with a virtual straight line extending in a direction from the wave source toward a center of the main surface, and passes through the center of the main surface; setting two or more square measurement points each having an area of 1 mm$^2$, at a pitch of 5 mm or more in a direction away from the center of the main surface, on a virtual second straight line which passes through the center of the main surface and intersects perpendicularly with the first straight line, in each of the first region and the second region; measuring the number of the dislocations at the measurement point, also converting the number of the dislocations into a converted value per unit area of 1 cm$^2$ from the measurement result; obtaining a numerical value by subtracting an average value of the converted values obtained from all the measurement points in the second region from an average value of the converted values obtained from all the measurement points in the first region; dividing an absolute value thereof by an average value of the converted values that were obtained from all the measurement points in the first region and the second region. This makes it possible to further decrease the cracking defect rate at the time of slicing.
[5] A group III-V compound semiconductor single crystal substrate according to one aspect of the present disclosure is a group III-V compound semiconductor single crystal substrate having a circular main surface, wherein the group III-V compound semiconductor single crystal substrate is a gallium arsenide single crystal substrate; the gallium arsenide single crystal substrate has a ripple-like pattern visually recognized on the main surface by being subjected to the following treatment; the ripple-like pattern is a pattern corresponding to a part of ripples which concentrically spread from a wave source; and the wave source is not positioned on the main surface, wherein the treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 5 minutes or more and 20 minutes or less.

The gallium arsenide single crystal substrate which is the group III-V compound semiconductor single crystal substrate having such characteristics can decrease the cracking defect rate at the time of slicing.

[6] It is preferable that a diameter of the gallium arsenide single crystal substrate is 75 mm or more and 205 mm or less. This makes it possible to decrease the cracking defect rate at the time of slicing of the gallium arsenide single crystal substrate having the diameter of 75 mm or more and 205 mm or less.

[7] It is preferable that a dislocation density of the main surface is 0 cm$^{-2}$ or more and 50 cm$^{-2}$ or less. This makes it possible to provide a gallium arsenide single crystal substrate in which the dislocation density is further decreased over the whole surface of the main surface.

[8] It is preferable that the degree of asymmetry of dislocations existing in the main surface is 2.0 or more, where the degree of asymmetry is calculated by dividing the main surface into a first region and a second region by a virtual first straight line that intersects perpendicularly with a virtual straight line extending in a direction from the wave source toward a center of the main surface, and passes through the center of the main surface, setting two or more square measurement points each having an area of 1 mm$^2$, at a pitch of 5 mm or more in a direction away from the center of the main surface, on a virtual second straight line which passes through the center of the main surface and intersects perpendicularly with the first straight line, in each of the first region and the second region, measuring the number of the dislocations at the measurement point, also converting the number of the dislocations into a converted value per unit area of 1 cm$^2$ from the measurement result, obtaining a numerical value by subtracting an average value of the converted values obtained from all the measurement points in the second region from an average value of the converted values obtained from all the measurement points in the first region; dividing an absolute value thereof by an average value of the converted values that were obtained from all the measurement points in the first region and the second region. This makes it possible to further decrease the cracking defect rate at the time of slicing.

[9] It is preferable that the main surface is a plane having an off angle of 0° or more and 15° or less from the {100} plane. This makes it possible that the main surface becomes a surface excellent in an electrical property and an optical property. Thereby, it becomes possible to decrease the cracking defect rate at the time of slicing, in the group III-V compound semiconductor single crystal substrate having a surface excellent in the electrical property and the optical property as the main surface.

[10] It is preferable that the average value of the residual strain is $3.5 \times 10^{-5}$ or less, which is the absolute value of the difference between the stretching strain in the direction along the diameter of the main surface and the stretching strain in the direction along the tangent line. This makes it possible to more sufficiently decrease the cracking defect rate at the time of slicing.

[11] It is preferable that in a polar coordinate that sets the center of the main surface as the origin point, and regards the virtual line segment as a starting line, which extends from the center of the main surface to a point 15 mm away from the outer periphery of the group III-V compound semiconductor single crystal substrate, along a direction from the center of the main surface toward the wave source, the residual strain which is the absolute value of the difference between the stretching strain in the direction along the diameter of the main surface and the stretching strain in the direction along the tangent line does not have such a distribution as to become an n-fold symmetry of which the center is set to the origin point, where n is an integer of 2 or more. This makes it possible to more sufficiently decrease the cracking defect rate at the time of slicing.

[12] It is preferable that the conductivity type of the group III-V compound semiconductor single crystal substrate is an electron attracting type. This makes it possible to decrease the cracking defect rate at the time of slicing, in the group III-V compound semiconductor single crystal substrate of which the conductivity type is the electron attracting type (hereinafter, also referred to as "n-type").

[13] It is preferable that the group III-V compound semiconductor single crystal substrate contains tin or sulfur as an impurity atom, where the group III-V compound semiconductor single crystal substrate is the indium phosphide single crystal substrate, and contains silicon as an impurity atom, where the group III-V compound semiconductor single crystal substrate is the gallium arsenide single crystal substrate. This makes it possible to decrease the cracking defect rate at the time of slicing, in each of the indium phosphide single crystal substrate containing tin or sulfur as the impurity atom and the gallium arsenide single crystal substrate containing silicon as the impurity atom.

[14] It is preferable that the atomic concentration of the impurity atoms is $1 \times 10^{16}$ cm$^{-3}$ or more and $1 \times 10^{19}$ cm$^{-3}$ or less. This makes it possible to provide a group III-V compound semiconductor single crystal substrate which contains such impurity atoms of an appropriate concentration as to set the conductivity type to be n-type.

[15] It is preferable that the impurity atoms show such a concentration distribution as to uniformly change in a direction from the wave source toward the center of the main surface, in the group III-V compound semiconductor single crystal substrate. This makes it possible to further decrease the cracking defect rate at the time of slicing, in the group III-V compound semiconductor single crystal substrate of which the conductivity type is the n-type.

[16] A method for manufacturing a group III-V compound semiconductor single crystal substrate according to an aspect of the present disclosure is a method for manufacturing a group III-V compound semiconductor single crystal substrate with the use of a crystal growth apparatus, the method comprising: obtaining a group III-V compound semiconductor single crystal, by bringing a seed crystal into contact with a raw material melt, and growing a crystalline solid on the raw material melt side of the seed crystal; and obtaining the group III-V compound semiconductor single crystal substrate having a circular main surface, by cutting out the group III-V compound semiconductor single crystal, wherein the crystal growth apparatus comprises at least a cylindrical crucible, and a heating element that heats the crucible; the crucible houses the seed crystal at a bottom portion thereof, and houses the raw material melt above the seed crystal in the crucible; and an interface between the crystalline solid and the raw material melt has a crossing angle of less than 90° with respect to the axis of the crucible. Due to the method for manufacturing the group III-V compound semiconductor single crystal substrate having such characteristics, the group III-V compound semiconductor single crystal substrate can be obtained in which the cracking defect rate at the time of slicing is decreased.

[Details of Embodiment]

Hereinafter, an embodiment according to the present disclosure (hereinafter also referred to as "the present embodiment") will be described in further detail, but the present disclosure is not limited thereto. The following description may be made with reference to a drawing, and an identical or corresponding element in the present specification and the drawing is denoted by the same reference sign, and the same description thereof will not be repeated. In addition, in the drawings, the scale of each constituent element is appropriately adjusted for easy understanding, and the scale of each constituent element illustrated in the drawings does not necessarily coincide with the scale of an actual constituent element.

As used in the present specification, the expression of a range in the format "A to B" means the upper limit and the lower limit of the range (that is, A or more and B or less), and when a unit is not written in A and a unit is written only in B, the unit for A and the unit for B are the same. Furthermore, as used in the present specification, when a chemical compound or the like is represented by a chemical formula, if the atomic ratio is not particularly limited, the chemical formula shall include all conventionally known atomic ratios, and should not necessarily be limited only to those within the stoichiometric range.

In the present specification, the "main surface" of the group III-V compound semiconductor single crystal substrate means both of the two circular surfaces on the substrate. When at least one of these two surfaces satisfies the Claims of the present disclosure, such a group III-V compound semiconductor single crystal substrate shall fall within the scope of the present invention. Furthermore, when the diameter of the group III-V compound semiconductor single crystal substrate is written as "50 mm," it means that the diameter is around 50 mm (about 50 to 50.8 mm) or 2 inches. When the diameter is written as "75 mm," it means that the diameter is around 75 mm (about 75 to 76.5 mm) or 3 inches. When the diameter is written as "100 mm," it means that the diameter is around 100 mm (about 95 to 105 mm) or 4 inches. When the diameter is written as "150 mm," it means that the diameter is around 150 mm (about 145 to 155 mm) or 6 inches. When the diameter is written as "200 mm," it means that the diameter is around 200 mm (about 195 to 205 mm) or 8 inches. The diameter can be measured with the use of a conventionally known outer diameter measuring instrument such as vernier calipers.

The group III-V compound semiconductor single crystal substrate has a "circular" main surface, which will be described later. In the present specification, the "circular shape" representing the shape of the main surface includes a geometrical circular shape; and in addition, a shape in the case where the main surface does not form a geometrical circular shape, due to the formation of at least one of a notch, an orientation flat (hereinafter also referred to as "OF"), or an index flat (hereinafter also referred to as "IF"). In other words, the "shape in the case where the main surface does not form the geometrical circular shape" means a shape in the case where the length of a line segment which extends from an arbitrary point on the notch, OF, and IF to the center of the main surface becomes short, among line segments which extend from an arbitrary point on the outer periphery of the main surface to the center of the main surface. In other words, in the present specification, the main surface shall be referred to as "circular" in shape, based on the shape before the notch, OF and IF are formed. For this reason, the position and size (length) of the center of the main surface and the diameter of the substrate shall be determined, on the basis of the circular shape before the notch, OF, IF, and the like are formed. The "shape in which the main surface does not form a geometrical circular shape" includes a shape in which all the lengths of line segments that extend from an arbitrary point on the outer periphery of the main surface to the center of the main surface are not necessarily the same, due to the shape of the group III-V compound semiconductor single crystal before being cut out as the group III-V compound semiconductor single crystal substrate. In this case, the center of the main surface shall refer to the position of the center of gravity, and the diameter of the substrate shall refer to a length of the longest line segment among line segments which extend from an arbitrary point on the outer periphery of the substrate to the center of the main surface.

In the crystallographic description in the present specification, an individual orientation is indicated by [ ], a family of orientations are indicated by < >, an individual plane is indicated by ( ), and a family of planes are indicated by { }. In addition, a crystallographic index that is negative is usually expressed by adding a "-" (bar) above the number, but when this is expressed in the present specification, a negative sign shall be added in front of the number.

[Group III-V Compound Semiconductor Single Crystal Substrate]

<First Embodiment: Indium phosphide single crystal substrate (InP substrate)>

The group III-V compound semiconductor single crystal substrate according to the present embodiment, for example, according to the first embodiment, has a circular main surface. Especially, the group III-V compound semiconductor single crystal substrate is an indium phosphide single crystal substrate (hereinafter, also referred to as "InP substrate"). The InP substrate has a ripple-like pattern which is visually recognized on the main surface, by being subjected to the following treatment. The ripple-like pattern is a pattern corresponding to a part of ripples which concentrically spread from the wave source. Furthermore, the wave source is not positioned on the main surface.

The treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less.

The InP substrate which is a group III-V compound semiconductor single crystal substrate having such characteristics can decrease the cracking defect rate in slicing, because the wave source of the ripple-like pattern is not positioned on the main surface.

It is preferable that a diameter of the InP substrate is 50 mm more and 155 mm or less. This makes it possible to decrease the cracking defect rate at the time of slicing, for the InP substrate having the diameter of 50 mm or more and 155 mm or less. Specifically, an InP substrate of which the diameter is 50 mm or more and 155 mm or less preferably refers to an InP substrate of which the diameter is 50 mm, 75 mm, 100 mm, or 150 mm, in other words, an InP substrate of which the diameter is 2 inches, 3 inches, 4 inches, or 6 inches. As described above, the diameter of the InP substrate can be measured with the use of a conventionally known outer diameter measuring instrument such as vernier calipers.

<Second Embodiment: Gallium arsenide single crystal substrate (GaAs substrate)>

The group III-V compound semiconductor single crystal substrate according to the present embodiment, for example, according to the second embodiment, has the circular main surface. Especially, the group III-V compound semiconductor single crystal substrate is a gallium arsenide single crystal substrate (hereinafter, also referred to as a "GaAs substrate"). The GaAs substrate has the ripple-like pattern visually recognized on the main surface by being subjected to the following treatment. The ripple-like pattern is a pattern corresponding to a part of ripples which concentrically spread from the wave source. Furthermore, the wave source is not positioned on the main surface.

The treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 5 minutes or more and 20 minutes or less.

The GaAs substrate which is a group III-V compound semiconductor single crystal substrate having such characteristics can decrease the cracking defect rate in slicing, because the wave source of the ripple-like pattern is not positioned on the main surface.

It is preferable that a diameter of the GaAs substrate is 75 mm or more and 205 mm or less. This makes it possible to decrease the cracking defect rate at the time of slicing, for the GaAs substrate having the diameter of 75 mm or more and 205 mm or less. Specifically, a GaAs substrate of which the diameter is 75 mm or more and 205 mm or less preferably refers to a GaAs substrate of which the diameter is 75 mm, 100 mm, 150 mm, or 200 mm, in other words, a GaAs substrate of which the diameter is 3 inches, 4 inches, 6 inches, or 8 inches. As described above, the diameter of the GaAs substrate can be measured with the use of a conventionally known outer diameter measuring instrument such as vernier calipers.

<Main Surface>

The group III-V compound semiconductor single crystal substrate according to the present embodiment has the circular main surface as described above. Furthermore, the group III-V compound semiconductor single crystal substrate (InP substrate and GaAs substrate) has the ripple-like pattern visually recognized on the main surface by being subjected to the following treatment. Specifically, the ripple-like pattern is visually recognized on the main surface by the treatment (hereinafter, also referred to as "etching treatment with the use of light") that horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less, when the group III-V compound semiconductor single crystal substrate is the indium phosphide single crystal substrate, and for 10 minutes or more and 20 minutes or less, when the group III-V compound semiconductor single crystal substrate is the gallium arsenide single crystal substrate. In other words, the ripple-like pattern is a pattern that appears on the main surface only after the main surface has been subjected to the etching treatment with the use of light.

(Ripple-like pattern, and wave source position of the ripple-like pattern)

The group III-V compound semiconductor single crystal substrate has the ripple-like pattern as described above. The ripple-like pattern is visually recognized on the main surface, by carrying out the etching treatment with the use of light onto the main surface, as described above. Fig. 1 is an illustrative diagram for describing the ripple-like pattern that is visually recognized on a main surface of the group III-V compound semiconductor single crystal substrate according to the present embodiment, by carrying out the etching treatment with the use of light onto the main surface, and the wave source position of the ripple-like pattern. In the present specification, the "ripple-like pattern" refers to a pattern that appears when, for example, an object falls on a water surface, and can be compared to a pattern of waves (so-called ripple), which spread out so as to draw multiple circles. Furthermore, the "wave source" of the ripple-like pattern refers to a starting point or a generation source from which the wave of the ripple-like pattern is generated. As shown in Fig. 1, ripple-like pattern P that appears on main surface S of group III-V compound semiconductor single crystal substrate 100 according to the present embodiment is a pattern corresponding to a part of ripples which concentrically spread from a wave source O, in other words, such a pattern that multiple arcs curved in the same direction are contiguous to each other. Furthermore, as shown in Fig. 1, wave source O of ripple-like pattern P is not positioned on main surface S.

The reason why the cracking defect rate at the time of slicing decreases in group III-V compound semiconductor single crystal substrate 100 having such a ripple-like pattern P is presumed to be based on the following factors, although the details are indistinct. Firstly, it is considered that ripple-like pattern P visually recognized on the main surface by the etching treatment with the use of light as described above is a pattern corresponding to the quantity of the concentration of impurity atoms to be added to group III-V compound semiconductor single crystal substrate 100, as a dopant or the like. In other words, it can be considered that ripple-like pattern P is an image in which the impurity atoms contained in group III-V compound semiconductor single crystal substrate 100 are visualized.

Fig. 2 is an illustrative diagram for describing a ripple-like pattern that is visually recognized on a main surface of a conventional group III-V compound semiconductor single crystal substrate, by carrying out etching treatment with the use of light onto the main surface, and a wave source position of the ripple-like pattern. As shown in Fig. 2, ripple-like pattern P visually recognized on main surface S by the etching treatment using light in a conventional group III-V compound semiconductor single crystal substrate 101 usually becomes a pattern which corresponds to ripples concentrically spreading from wave source O, and in which wave source O is positioned at the center or near the center of main surface S. Such a group III-V compound semiconductor single crystal substrate 101 is achieved by making the interface between the crystalline solid to be grown on the raw material melt side of the seed crystal and the raw material melt horizontal (or substantially horizontal), in the process of growing the group III-V compound semiconductor single crystal serving as the raw material in the crucible provided in the crystal growth apparatus. In this case, the impurity atoms contained in group III-V compound semiconductor single crystal substrate 101 correspond to ripple-like pattern P as described above, and show a distribution that concentrically spreads from the center or the vicinity of the center of main surface S. At this time, the strain (hereinafter, also referred to as "residual strain"), which is generated in group III-V compound semiconductor single crystal substrate 101 based on the impurity atoms, shows a distribution which is point-symmetric (specifically, 4-fold symmetric) around the wave source, when being expressed in the polar coordinate that sets wave source O as the origin point (see Fig. 4). Thereby, it is understood that the stress of the residual strain resists being released on the substrate, in the conventional group III-V compound semiconductor single crystal substrate 101. Accordingly, it becomes easy for the stress of the residual strain to be released at the time of slicing for obtaining the group III-V compound semiconductor single crystal substrate 101 from the group III-V compound semiconductor single crystal, and accordingly, it is considered that a crack of the substrate occurs at a certain rate.

On the other hand, as shown in Fig. 1, ripple-like pattern P in group III-V compound semiconductor single crystal substrate 100 according to the present embodiment has a wave source O in the outside of main surface S. In other words, wave source O is not positioned on main surface S. Because of this, ripple-like pattern P of the group III-V compound semiconductor single crystal substrate according to the present embodiment becomes a pattern which corresponds to a part of ripples concentrically spreading from wave source O, in other words, such a pattern that multiple arcs curved in the same direction are contiguous to each other. Such a group III-V compound semiconductor single crystal substrate 100 is achieved by the interface between the crystalline solid to be grown on the raw material melt side of the seed crystal and the raw material melt, which is not horizontal but has a crossing angle of less than 90° with respect to an axis of a crucible, as will be exemplified, for example, in the item of [Method for Manufacturing group III-V compound semiconductor single crystal substrate] that will be described later, in a process of growing the group III-V compound semiconductor single crystal, which is the raw material, in the crucible provided in a crystal growth apparatus. In this case, the impurity atoms contained in group III-V compound semiconductor single crystal substrate 100 show a distribution in which multiple arcs curved in the same direction are contiguous to each other, on main surface S in correspondence with ripple-like pattern P as described above. At this time, when the residual strain which is generated in group III-V compound semiconductor single crystal substrate 100 on the basis of the impurity atoms is expressed in the polar coordinate that sets the center of the main surface S to the origin point, the residual strain does not show a distribution of an n-fold symmetry (where n is an integer of 2 or more) around the origin point, but can show a distribution of simple one-fold symmetry, particularly, a distribution of approximate mirror symmetry (see Fig. 3). Thereby, it is understood that the stress of the residual strain tends to be easily released on the substrate, in group III-V compound semiconductor single crystal substrate 100 according to the present embodiment (for example, the stress tends to be easily released at an intersection of an outer periphery of the main surface and left and right ends of the arc). Accordingly, it is considered that the stress of the residual strain does not need to be released at the time of slicing for obtaining the group III-V compound semiconductor single crystal substrate 100 from the group III-V compound semiconductor single crystal, and accordingly, the cracking defect rate of the substrate decreases.

Here, the etching treatment with the use of light will be described in detail. Firstly, a group III-V compound semiconductor single crystal substrate is prepared in which at least one of two surfaces serving as main surfaces is polished to an arithmetic mean roughness of Ra 0.1 nm or more and 0.5 nm or less to have a polished surface. Furthermore, the substrate is horizontally arranged at a position below 10 mm in a depth direction from the liquid level of a mixed liquid at 25°C, which contains 10 g of chromium (VI) oxide, 10 mL of a hydrofluoric acid solution having a concentration of 50% by mass, and 400 mL of pure water, after the polished surface was set to the upper surface. Next, when the substrate is, for example, the indium phosphide single crystal substrate, the polished surface is subjected to the etching treatment, by causing a reflection type incandescent electric lamp of 500 W (for example, trade name: an "EYELAMP (registered trademark)", Iwasaki Electric Co., Ltd.) to radiate light toward the polished surface from a position which is spaced 20 cm upward from the liquid level, for 1 to 2 hours. Thereby, a pattern can be formed on the polished surface. On the other hand, when the substrate is, for example, the gallium arsenide single crystal substrate, the polished surface is subjected to the etching treatment, by causing the lamp to radiate the light toward the polished surface from the position which is spaced 20 cm upward from the liquid level, for 5 to 20 minutes. Thereby, a pattern can be formed on the polished surface. Finally, the pattern formed on the polished surface is visually observed, and thereby, it is possible to identify whether or not the pattern is a ripple-like pattern, and if the pattern is the ripple-like pattern, whether or not the wave source is positioned on the main surface.

The reason why a time period in which the reflection type incandescent electric lamp irradiates the main surface with light (hereinafter, also referred to as "etching time") is different between a case where the group III-V compound semiconductor single crystal substrate is the indium phosphide single crystal substrate and a case where the group III-V compound semiconductor single crystal substrate is the gallium arsenide single crystal substrate, and there is a range in the etching time period is for making the pattern (ripple-like pattern) formed on the polished surface clearer. Accordingly, in the present disclosure, it is possible to extend or shorten the etching time period within the above described range, for the purpose of making the pattern to be formed on the polished surface clearer, regardless of whether the group III-V compound semiconductor single crystal substrate is the indium phosphide single crystal substrate or the gallium arsenide single crystal substrate. Furthermore, it is also possible to carry out fine adjustment such as increasing or decreasing the intensity of light. Note that the temperature of the mixed liquid (25°C) means the temperature at the time of starting the etching treatment with the use of light. Accordingly, a temperature of the mixed liquid fluctuates during the etching treatment due to, for example, thermal energy of light from the reflection type incandescent electric lamp, in some cases. In addition, in the etching treatment, it is preferable to swing the substrate existing in the mixed liquid at predetermined time intervals (for example, every minute), in order to make a pattern to be formed on the polished surface clearer.

(Residual Strain)

In the group III-V compound semiconductor single crystal substrate according to the present embodiment, it is preferable that the average value of the residual strain, which is the absolute value of the difference between the stretching strain in the direction along the diameter of the main surface and the stretching strain in the direction along the tangent line, is $3.5 \times 10^{-5}$ or less. Due to the average value of the residual strain being $3.5 \times 10^{-5}$ or less, the stress does not need to be released at the time of slicing for obtaining the group III-V compound semiconductor single crystal substrate, and it becomes possible to decrease the cracking defect rate of the substrate. The lower limit of the average value of the residual strain is not particularly limited, but is ordinarily $1.0 \times 10^{-6}$ or more practically. Here, in the present specification, there is a case where the stretching strain in the direction along the diameter of the main surface is represented by "Sr", and the stretching strain in the direction along the tangent line of the main surface is represented by "St".

Especially, the average value of the residual strain can have a more preferable value, depending on whether the group III-V compound semiconductor single crystal substrate is an InP substrate or a GaAs substrate, or on the type of impurity atom contained in the substrate, the difference in a size of the diameter of the substrate, and the like. For example, in the case of an InP substrate which has a diameter of 50 mm and contains tin as an impurity atom, it is more preferable that the average value of the residual strain is $5.9 \times 10^{-6}$ or less, and in the case of an InP substrate which has the diameter of 50 mm and contains sulfur as an impurity atom, it is more preferable that the average value of the residual strain is $5.4 \times 10^{-6}$ or less.

In the case of an InP substrate which has a diameter of 75 mm and contains tin as an impurity atom, it is more preferable that the average value of the residual strain is $1.1 \times 10^{-5}$ or less, and in the case of an InP substrate which has the diameter of 75 mm and contains sulfur as the impurity atom, it is more preferable that the average value of the residual strain is $9.5 \times 10^{-6}$ or less. In the case of an InP substrate which has a diameter of 100 mm and contains tin as the impurity atom, it is more preferable that the average value of the residual strain is $2.2 \times 10^{-5}$ or less, and in the case of an InP substrate which has the diameter of 100 mm and contains sulfur as the impurity atom, it is more preferable that the average value of the residual strain is $2.0 \times 10^{-5}$ or less. In the case of an InP substrate which has a diameter of 150 mm and contains tin as the impurity atom, it is more preferable that the average value of the residual strain is $3.9 \times 10^{-5}$ or less, and in the case of an InP substrate which has the diameter of 150 mm and contains sulfur as the impurity atom, it is more preferable that the average value of the residual strain is $3.4 \times 10^{-6}$ or less.

In the case of a GaAs substrate which has a diameter of 75 mm and contains silicon as an impurity atom, it is more preferable that the average value of the residual strain is $8.2 \times 10^{-6}$ or less; in the case of a GaAs substrate which has a diameter of 100 mm and contains silicon as the impurity atom, it is more preferable that the average value of the residual strain is $1.0 \times 10^{-5}$ or less; in the case of a GaAs substrate which has a diameter of 150 mm and contains silicon as the impurity atom, it is more preferable that the average value of the residual strain is $2.0 \times 10^{-5}$ or less; and in the case of a GaAs substrate which has a diameter of 200 mm and contains silicon as the impurity atom, it is more preferable that the average value of the residual strain is $3.5 \times 10^{-5}$ or less.

Regarding the residual strain that is the absolute value of the difference between the stretching strain in the direction along the diameter of the main surface and the stretching strain in the direction along the tangent line, it is convenient to show the residual strain in the polar coordinate that sets the center of the main surface as the origin point, and regards the virtual line segment as the starting line, which extends from the center of the main surface to a point 15 mm away from the outer periphery of the group III-V compound semiconductor single crystal substrate, along a direction from the center of the main surface toward the wave source, for specifying the quantity and distribution of the residual strain contained in the group III-V compound semiconductor single crystal substrate. It is because it becomes possible due to the polar coordinate to visually understand the distribution of the residual strain in the group III-V compound semiconductor single crystal substrate, and to easily grasp the ease of release of the residual strain, in other words, the ease of occurrence of cracking defects (quantity of cracking defect rate), and the like, at the time of slicing for obtaining the substrate. In this case, it is preferable that the residual strain in the group III-V compound semiconductor single crystal substrate according to the present embodiment does not have a distribution that is n-fold symmetry around the origin point in the polar coordinate, and that n is an integer of 2 or more. Specifically, it is preferable that the residual strain shows a distribution that is one-fold symmetry around the origin point in the polar coordinate. Especially, it is preferable that the residual strain shows a distribution having a symmetry close to the mirror symmetry (hereinafter, also referred to as "approximate mirror symmetry") which regards a virtual straight line that extends from the center of the main surface toward the wave source, as a central axis, from the viewpoint of further decreasing the cracking defect rate of the substrate. In the present specification, "n-fold symmetry" around the origin point means a symmetry characterized as a rotational symmetry around the origin point, and specifically means a symmetry in which the distribution overlaps with itself when being rotated by $(360/n)°$ around the origin point. The aforementioned n is an integer of 2 or more, and for example, "three-fold symmetry" means n=3 and a symmetry in which the distribution overlaps with itself when being rotated by 120°.

The residual strain (hereinafter also referred to as "|Sr-St|"), which is the absolute value of the difference between the stretching strain in the direction along the diameter of the main surface and the stretching strain in the direction along the tangent line, can be measured on the basis of a photoelastic method described in Appl. Phys. Lett. 47 (1985) pp. 365 to 367. Firstly, a group III-V compound semiconductor single crystal substrate is prepared, in which at least one of the two main surfaces is a polished surface by being polished to an arithmetic mean roughness Ra of 0.1 nm or more and 0.5 nm or less, as in a procedure for carrying out the etching treatment with the use of light described above. Next, the photoelastic method is applied to the polished surface, and thereby, it is possible to measure the residual strain existing on the whole surface of the polished surface. Especially, in the photoelastic method, the residual strain can be determined as the absolute value |Sr-St|. In the photoelastic method, the residual strain (|St-St|) is defined by the following Expression (1).

[Expression 1]

$$|S_r - S_t| = k\delta\left[\left(\frac{\cos 2\phi}{P_{11} - P_{12}}\right)^2 + \left(\frac{\sin 2\phi}{P_{44}}\right)^2\right]^{1/2}$$

$$\cdots (1)$$

In the Expression (1), $k = (\lambda / \pi dn_0^3)$.

In the Expression (1), $\lambda$ represents a wavelength of light to be used for measurement, d represents a thickness of the group III-V compound semiconductor single crystal substrate to be used for measurement, $n_0$ represents an index of refraction, $\delta$ represents a phase difference caused by the birefringence of the sample to be measured, $\phi$ represents a principal vibration azimuth, and $p_{11}$, $p_{12}$, and $p_{44}$ each represent a photoelastic constant.

According to the photoelastic method, it is possible to obtain the residual strain ($|Sr-St|$) on the whole main surface of the substrate, by measurements of only the phase difference $\delta$ and the principal vibration azimuth $\phi$ which are caused by the birefringence of the sample to be measured.

Furthermore, it is possible to show the residual strain in the polar coordinate that sets the center of the main surface as the origin point, and regards the virtual line segment as the starting line, which extends from the center of the main surface to a point 15 mm away from the outer periphery of the group III-V compound semiconductor single crystal substrate, along the direction from the center of the main surface toward the wave source, on the basis of the residual strain ($|Sr-St|$) in the whole main surface of the substrate, for example, as shown in Fig. 3 and Fig. 4.

Fig. 3 is an illustrative diagram showing the residual strain which is the absolute value of the difference between the stretching strain in the direction along the diameter of the main surface and the stretching strain in the direction along the tangent line, regarding the group III-V compound semiconductor single crystal substrate according to the present embodiment, in the polar coordinate that sets the center of the main surface as the origin point, and regards the virtual line segment as the starting line, which extends from the center of the main surface to a point 15 mm away from the outer periphery of the group III-V compound semiconductor single crystal substrate, along the direction from the center of the main surface toward the wave source. Fig. 4 is an illustrative diagram showing the residual strain which is the absolute value of the difference between the stretching strain in the direction along the diameter of the main surface and the stretching strain in the direction along the tangent line, regarding a conventional group III-V compound semiconductor single crystal substrate, in the polar coordinate that sets the center of the main surface as the origin point, and regards the virtual line segment as the starting line, which extends from the center of the main surface to a point 15 mm away from the outer periphery of the group III-V compound semiconductor single crystal substrate, along the direction from the center of the main surface toward the wave source.

As is understood from comparison between Fig. 3 and Fig. 4, the residual strain on the main surface of the group III-V compound semiconductor single crystal substrate according to the present embodiment does not have a distribution that is n-fold symmetry (where n is an integer of 2 or more) in the polar coordinate, but shows a distribution that is one-fold symmetry around the origin point. Especially, according to Fig. 3, it is understood that the residual strain of the group III-V compound semiconductor single crystal substrate according to the present embodiment shows a distribution that becomes approximate mirror symmetry regarding a virtual straight line which extends from the center of the main surface toward the wave source, as a central axis. In this way, it is understood that the group III-V compound semiconductor single crystal substrate according to the present embodiment has a site on the substrate, at which the stress of the residual strain is easily released, because of showing the distribution which is one-fold symmetry, particularly, approximate mirror symmetry around the origin point in the polar coordinate. On the other hand, it is understood that because the conventional group III-V compound semiconductor single crystal substrate shows a distribution of a four-fold symmetry with the origin point as the center, in the polar coordinate, the site does not exist on the substrate, at which the stress of the residual strain is easily released.

In the case where the residual strain is measured, in the group III-V compound semiconductor single crystal substrate according to the present embodiment, the measurement may be executed before the dislocation density of the main surface is determined, which will be described later, or may be executed after the dislocation density of the main surface has been determined. When the residual strain is measured after the dislocation density of the main surface has been obtained, it is possible to polish both surfaces of the main surface for the purpose of removing corrosion pittings and for the purpose of making the main surface the polished surface described above, because the corrosion pittings corresponding to dislocations (etch pits) are formed on the main surface.

(Off Angle)

It is preferable that the main surface is a plane having an off angle of 0° or more and 15° or less from the {100} plane. When the main surface has the off angle of 0° or more and 15° or less from the {100} plane, the main surface of the group III-V compound semiconductor single crystal substrate becomes a plane having an orientation that is excellent in an electrical property and an optical property. Thereby, the present embodiment can decrease the cracking defect rate of a group III-V compound semiconductor single crystal substrate having a plane that is excellent in an electrical property and an optical property, as the main surface.

Such group III-V compound semiconductor single crystal substrate can be obtained by slicing the {100} just plane having no off angle as the main surface, from a group III-V compound semiconductor single crystal that is the raw material of the group III-V compound semiconductor single crystal substrate. Alternatively, the group III-V compound semiconductor single crystal substrate can be obtained by executing a conventionally known inclined slicing method for the group III-V compound semiconductor single crystal so that the plane having the off angle of more than 0° and 15° or less from the {100} plane becomes the main surface. When such a raw material (group III-V compound semiconductor single crystal) is obtained, it is preferable that a growth direction of the group III-V compound semiconductor single crystal is a <100> direction. Here, in the present disclosure, the "off angle" shall have an accuracy error of $\pm 0.5°$. For example, when the main surface is a {100} just plane, the main surface has a possibility of having an off angle of -0.5 to 0.5° from the {100} plane. In addition, for example, when the main surface is a plane having an off angle of 15° from the {100} plane, there is a possibility that the main surface has an off angle of 14.5 to 15.5° from the {100} plane.

It is possible to measure the off angle from the {100} plane on the main surface of the group III-V compound semiconductor single crystal, with the use of a conventionally known crystallographic orientation measuring apparatus (for example, trade name (product number): "2991G2", manufactured by Rigaku Corporation).

(Dislocation Density)

When the group III-V compound semiconductor single crystal substrate is the InP substrate, it is preferable that a dislocation density of the main surface is 0 cm$^{-2}$ or more and 2000 cm$^{-2}$ or less. It is more preferable that the dislocation density of the main surface is 0 cm$^{-2}$ or more and 1500 cm$^{-2}$ or less. On the other hand, when the group III-V compound semiconductor single crystal substrate is the GaAs substrate, it is preferable that the dislocation density of the main surface is 0 cm$^{-2}$ or more and 50 cm$^{-2}$ or less. It is more preferable that the dislocation density of the main surface is 0 cm$^{-2}$ or more and 30 cm$^{-2}$ or less. This makes it possible to provide a group III-V compound semiconductor single crystal substrate (InP substrate and GaAs substrate), in which the dislocation density is further decreased over the whole surface of the main surface. Thereby, the present embodiment can decrease the cracking defect rate of the group III-V compound semiconductor single crystal substrate in which the dislocation density is decreased over the whole main surface.

Especially, the dislocation density of the main surface can have a more preferable value, depending on whether the group III-V compound semiconductor single crystal substrate is the InP substrate or the GaAs substrate, or on the type of impurity atom contained in the substrate, the difference in a size of the diameter of the substrate, and the like. For example, in the case of the InP substrate which has the diameter of 50 mm and contains tin as the impurity atom, it is more preferable that the dislocation density of the main surface is 1000 cm$^{-2}$ or less, and in the case of the InP substrate which has the diameter of 50 mm and contains sulfur as the impurity atom, it is more preferable that the dislocation density of the main surface is 200 cm$^{-2}$.

In the case of the InP substrate which has the diameter of 75 mm and contains tin as the impurity atom, it is more preferable that the dislocation density of the main surface is 2000 cm$^{-2}$ or less, and in the case of the InP substrate which has the diameter of 75 mm and contains sulfur as the impurity atom, it is more preferable that the dislocation density of the main surface is 350 cm$^{-2}$ or less. In the case of the InP substrate which has the diameter of 100 mm and contains tin as the impurity atom, it is more preferable that the dislocation density of the main surface is 2000 cm$^{-2}$ or less, and in the case of the InP substrate which has the diameter of 100 mm and contains sulfur as the impurity atom, it is more preferable that the dislocation density of the main surface is 600 cm$^{-2}$ or less. In the case of the InP substrate which has the diameter of 150 mm and contains tin as the impurity atom, it is more preferable that the dislocation density of the main surface is 2000 cm$^{-2}$ or less, and in the case of the InP substrate which has the diameter of 150 mm and contains sulfur as the impurity atom, it is more preferable that the dislocation density of the main surface is 700 cm$^{-2}$ or less.

In the case of the GaAs substrate which has the diameter of 75 mm and contains silicon as the impurity atom, it is more preferable that the dislocation density of the main surface is 25 cm$^{-2}$ or less; in the case of the GaAs substrate which has the diameter of 100 mm and contains silicon as the impurity atom, it is more preferable that the dislocation density of the main surface is 35 cm$^{-2}$ or less; in the case of the GaAs substrate which has the diameter of 150 mm and contains silicon as the impurity atom, it is more preferable that the dislocation density of the main surface is 35 cm$^{-2}$ or less; and in the case of the GaAs substrate which has the diameter of 200 mm and contains silicon as the impurity atom, it is more preferable that the dislocation density of the main surface is 90 cm$^{-2}$ or less.

In the present specification, the "dislocation" and "dislocation density" of the main surface shall mean "etch pit" and "etch pit density (Etch Pit Density, hereinafter also referred to as "EPD")", respectively. The "etch pit" refers to a corrosion pitting which is formed on the surface of the group III-V compound semiconductor single crystal substrate by treatment of the surface with a chemical agent. Specifically, when the group III-V compound semiconductor single crystal substrate is the indium phosphide single crystal substrate, the "etch pit" refers to a corrosion pitting which is formed in the main surface when the substrate has been immersed for 1 to 5 minutes in a chemical liquid at 25°C which contains hydrogen bromide and phosphoric acid so that a mass ratio of hydrogen bromide: phosphoric acid becomes 1:2. Furthermore, when the group III-V compound semiconductor single crystal substrate is the gallium arsenide single crystal substrate, the "etch pit" refers to a corrosion pitting which is formed in the main surface when the substrate has been immersed in molten potassium hydroxide at 600°C for 45 minutes. When the main surface of the group III-V compound semiconductor single crystal substrate is a polished surface which has been polished, the polished surface, for example, of the indium phosphide single crystal substrate can be pretreated with the use of reverse aqua regia, before the substrate is immersed in the chemical liquid or the like; and the polished surface, for example, of the gallium arsenide single crystal substrate can be pretreated with the use of sulfuric acid and hydrogen peroxide. This makes it possible to further clarify the corrosion pitting on the main surface. The corrosion pitting appears as a white spot when the main surface of the group III-V compound semiconductor single crystal substrate has been observed with an optical microscope or the like. The etch pit is not scientifically synonymous with the dislocation, but can be regarded as equivalent to the dislocation in the present technical field.

With reference to Fig. 5, the method for measuring the etch pit which is formed on the main surface of the group III-V compound semiconductor single crystal substrate and the method for calculating the EPD will be described below, while taking a case where the group III-V compound semiconductor single crystal substrate is the GaAs substrate having the diameter of 150 mm, as an example. Fig. 5 is an illustrative diagram for describing measurement points at 69 points that are set on the main surface, for the purpose of obtaining the dislocation density of the main surface, regarding the group III-V compound semiconductor single crystal substrate according to the present embodiment.

Firstly, the main surface of group III-V compound semiconductor single crystal substrate (GaAs substrate) 100 is immersed in molten potassium hydroxide at 600°C for 45 minutes. As an immersion method, a conventionally known method can be used. Furthermore, group III-V compound semiconductor single crystal substrate 100 is taken out from the molten potassium hydroxide. Subsequently, as shown in Fig. 5, measurement points M (one measurement point M is a square having an area of 1 mm$^2$, in other words, a size of 1 mm $\times$ 1 mm) at 69 points are set in main surface S of group III-V compound semiconductor single crystal substrate 100. The number of etch pits is measured for each of measurement points M at 69 points, with the use of a known optical microscope (for example, trade name: "ECLIPSE (registered trademark) LV150N", manufactured by Nikon Corporation), at a magnification of 100 times. Finally, the numbers of etch pits measured at the measurement points M at 69 points are each converted into numerical value per unit area of 1 cm$^2$. Thereby, a numerical value per area of 1 cm$^2$ of the etch pit are obtained at 69 points, and the average value of numerical values at the 69 points can be calculated as the EPD.

According to the above described method, it is possible to measure the number of etch pits by making one measurement point correspond to one visual field (size of 1 mm $\times$ 1 mm). When group III-V compound semiconductor single crystal substrate 100 is the InP substrate, the method of measuring the etch pits which are formed on main surface S and the method for calculating the EPD can be determined in the same way as the method for measuring the etch pits and the method for calculating the EPD in the GaAs substrate described above, except that the main surface is immersed in the chemical liquid containing hydrogen bromide and phosphoric acid at a mass ratio of 1:2 at 25°C for 1 to 5 minutes.

Here, in the substrate shown in Fig. 5, the measurement points M at 69 points are provided at five, seven, nine, nine, nine, nine, nine, seven, and five positions in order from the right side, in a direction perpendicular to an orientation flat OF provided at the upper portion. A space I of 15 mm is provided between these measurement points M from each other. Specifically, when the diameter of the group III-V compound semiconductor single crystal substrate is 150 mm, space I between one measurement point M and another measurement point M most adjacent to the one measurement point M is set to 15 mm, and thereby, it becomes possible to set the number of the measurement points M to 69 points within main surface S.

When the diameter of the group III-V compound semiconductor single crystal substrate is 50 mm, the measurement points M can be set to 69 points within main surface S, by setting space I between one measurement point M and another measurement point M most adjacent to the one measurement point M, to 5 mm. Similarly, when the diameter of the group III-V compound semiconductor single crystal substrate is 75 mm, the measurement points M can be set to 69 points within main surface S, by setting space I between one measurement point M and another measurement point M most adjacent to the one measurement point M, to 7.5 mm. When the diameter of the group III-V compound semiconductor single crystal substrate is 100 mm, the measurement points M at 69 points can be set to 69 points within main surface S, by setting space I between one measurement point M and another measurement point M most adjacent to the one measurement point M, to 10 mm. When the diameter of the group III-V compound semiconductor single crystal substrate is 200 mm, the measurement points M can be set to 69 points within main surface S, by setting space I between one measurement point M and another measurement point M most adjacent to the one measurement point M, to 20 mm.

(Degree of Asymmetry of Dislocation)

When the group III-V compound semiconductor single crystal substrate is the InP substrate, it is preferable for the degree of asymmetry of dislocations existing in the main surface to be 1.8 or more, and is more preferable to be 2.0 or more.

Furthermore, when the group III-V compound semiconductor single crystal substrate is the GaAs substrate, it is preferable for the degree of asymmetry of dislocations to be 2.0 or more, and is more preferable to be 2.3 or more. The degree of asymmetry is calculated by dividing the main surface into a first region and a second region by a virtual first straight line that intersects perpendicularly with a virtual straight line extending in a direction from the wave source toward a center of the main surface, and passes through the center of the main surface; setting two or more square measurement points each having an area of 1 $mm^2$, at a pitch of 5 mm or more in a direction away from the center of the main surface, on a virtual second straight line which passes through the center of the main surface and intersects perpendicularly with the first straight line, in each of the first region and the second region; measuring the number of the dislocations at the measurement point, also converting the number of the dislocations into a converted value per unit area of 1 $cm^2$ from the measurement result; obtaining a numerical value by subtracting an average value of the converted values obtained from all the measurement points in the second region, from an average value of the converted values obtained from all the measurement points in the first region; and dividing an absolute value thereof by an average value of the converted values that were obtained from all the measurement points in the first region and the second region.

In the present specification, the "degree of asymmetry of dislocations" means an index indicating how much the number of dislocations differs after comparison of dislocations existing in each of a first region and a second region, in the case where the main surface has been divided into the first region and the second region by the virtual first straight line that intersects perpendicularly with the virtual straight line extending in a direction from the wave source toward the center of the main surface, and passes through the center of the main surface. As the numerical value of the "degree of asymmetry of dislocations" is larger, the cracking defect rate at the time of slicing can be further decreased, although the detailed reason is indistinct. The "degree of asymmetry of dislocations" of the group III-V compound semiconductor single crystal substrate according to the present embodiment can show a larger numerical value than that of the conventional group III-V compound semiconductor single crystal substrate, for the following reasons.

Because, as described above, in the case where the main surface of the group III-V compound semiconductor single crystal substrate according to the present embodiment has been subjected to the etching treatment with the use of light, the ripple-like pattern in which a wave source is not positioned on the main surface is visually recognized on the main surface. On the other hand, in the case where the main surface of the conventional group III-V compound semiconductor single crystal substrate has been subjected to the etching treatment with the use of light, the ripple-like pattern in which the wave source is positioned in the center or in the vicinity of the center on the main surface is visually recognized on the main surface. At this time, the ripple-like pattern in the conventional group III-V compound semiconductor single crystal substrate becomes a pattern corresponding to ripples which concentrically spread from the wave source positioned at the center or at the vicinity of the center of the main surface as described above, and accordingly, the number of dislocations existing in the first region and the number of dislocations existing in the second region become the same or similar; and it is considered that the "degree of asymmetry of dislocations" thereby becomes small. On the other hand, the ripple-like pattern in the group III-V compound semiconductor single crystal substrate according to the present embodiment becomes such a pattern that multiple arcs curved in the same direction are contiguous to each other as described above, and accordingly, the number of dislocations existing in the first region and the second region becomes different; and it is considered that the "degree of asymmetry of dislocations" also becomes large. As the numerical value of the "degree of asymmetry of dislocation" is larger, an orientation at which the strain is lower appears in the group III-V compound semiconductor single crystal, and accordingly, when the substrate is obtained by slicing of the above single crystal along the orientation, it is considered possible to further decrease the cracking defect rate.

In the case where the group III-V compound semiconductor single crystal substrate according to the present embodiment is the InP substrate, the degree of asymmetry of dislocations can be 1.8 or more. In contrast to this, in the conventional InP substrate, the degree of asymmetry usually becomes less than 1.8. In the case where the group III-V compound semiconductor single crystal substrate according to the present embodiment is the GaAs substrate, the degree of asymmetry of dislocations can be 2.0 or more. In contrast to this, in the conventional GaAs substrate, the degree of asymmetry usually becomes less than 2.0.

With reference to Fig. 6, a method for calculating the "degree of asymmetry of dislocations" existing in the main surface will be specifically described below. Fig. 6 is an illustrative diagram for describing a method of obtaining the degree of asymmetry of dislocations existing on the main surface of the group III-V compound semiconductor single crystal substrate according to the present embodiment, by using the ripple-like pattern shown in Fig. 1 and the measurement points at 69 points shown in Fig. 5.

Firstly, main surface S of group III-V compound semiconductor single crystal substrate 100 is subjected to the above described etching treatment with the use of light, and thereby, ripple-like pattern P is formed on main surface S. A position of the wave source is specified from the ripple-like pattern P, and then, a virtual straight line extending in a direction from wave source to the center of main surface S is set on main surface S. Subsequently, a position of a virtual first straight line L1 on main surface S is specified, which intersects perpendicularly with the virtual straight line and passes through the center of the main surface. Furthermore, a position of virtual first straight line L1 is recorded on main surface S, by a method of breaking the outer periphery of group III-V compound semiconductor single crystal substrate 100, attaching a mark onto main surface S, or the like. After that, main surface S is polished to thereby remove the ripple-like pattern from main surface S.

Next, measurement points M at 69 points are set on main surface S in the same manner as in the method of measuring the dislocation density described above. Furthermore, main surface S is divided into a first region R1 and a second region R2, on the basis of virtual first straight line L1 recorded on main surface S. Subsequently, a virtual second straight line L2 is provided which passes through the center of main surface S and intersects perpendicularly with first straight line L1, and measurement points M are selected which overlap with second straight line L2, in each of first region R1 and second region R2.

Next, the number of dislocations (etch pits) is measured at measurement points M selected in each of first region R1 and second region R2, and also, the number of dislocations is converted into a converted value per unit area of 1 cm$^2$ from the measurement result. Furthermore, an average value of the converted values obtained from all measurement points M selected in the second region R2 is subtracted from an average value of the converted values obtained from all measurement points M selected in first region R1. Finally, the absolute value of the numerical value obtained by the subtraction is divided by the average value of the converted values obtained from all measurement points M selected in each of first region R1 and second region R2. The "degree of asymmetry of dislocation" can be determined by the above method.

Here, in the case where virtual second straight line L2 and measurement point M do not overlap at two or more positions, in each of first region R1 and second region R2, there is a possibility that the average value of the converted values for obtaining the "degree of asymmetry of dislocations" cannot be calculated. In such a case, it becomes possible to calculate the average value of the converted values and the like, by regarding measurement point M closest to virtual second straight line L2 and measurement point M next closest to virtual second straight line L2 as measurement points M which overlap each second straight line L2, in each of first region R1 and second region R2, and by measuring the number of dislocations at measurement points M. Furthermore, when the diameter of group III-V compound semiconductor single crystal substrate 100 is 50 mm, space I between one measurement point M and another measurement point M that is most adjacent to one measurement point M becomes 5 mm, and accordingly, when the diameter of group III-V compound semiconductor single crystal substrate 100 from which the "degree of asymmetry of dislocation" is determined is 50 mm or more, space I (pitch) between measurement points M that overlap with virtual second straight line L2 becomes necessarily 5 mm or more.

<Conductivity Type>

The group III-V compound semiconductor single crystal substrate according to the present embodiment can be imparted with an electron attracting type (n-type) of conductivity, by addition of an impurity atom to a seed crystal which becomes the raw material. In other words, it is preferable that the conductivity type of the group III-V compound semiconductor single crystal substrate is the n-type. Especially, the group III-V compound semiconductor single crystal substrate preferably contains tin or sulfur as an impurity atom, in the case of being the indium phosphide single crystal substrate, and preferably contains silicon in the case of being the gallium arsenide single crystal substrate. This makes it possible to decrease the cracking defect rate at the time of slicing, in the group III-V compound semiconductor single crystal substrate of which the conductivity type is the n-type.

For example, the InP substrate can contain both or either of S (sulfur) atom and Sn (tin) atom, in order to impart the n-type of conductivity thereto. A conductive InP substrate containing both or either of an S (sulfur) atom and an Sn (tin) atom can, for example, have a specific resistance of 1 Ω·cm or less. The GaAs substrate can contain the Si (silicon) atom in order to impart the n-type of conductivity thereto.

It is preferable that the atomic concentration of the impurity atoms (S, Sn, or Si) is $1 \times 10^{16}$ cm$^{-3}$ or more and $1 \times 10^{19}$ cm$^{-3}$ or less. It is more preferable that the atomic concentration of the impurity atoms is $1 \times 10^{18}$ cm$^{-3}$ or more and $1 \times 10^{19}$ cm$^{-3}$ or less. An atomic concentration of the impurity atoms can be measured with the use of GDMS (glow discharge mass spectrometry).

It is preferable that the impurity atoms show such a concentration distribution as to uniformly change in a direction from the wave source toward the center of the main surface, in the group III-V compound semiconductor single crystal substrate. Specifically, in group III-V compound semiconductor single crystal substrate 100 that has wave source O in the outside of main surface S, and has such a pattern (ripple-like pattern P) that multiple arcs curved in the same direction are contiguous to each other as shown in Fig. 1, the impurity atoms can show a concentration distribution that uniformly changes in a direction from wave source O toward the center of main surface S. It is more preferable that the impurity atoms show such a concentration distribution as to uniformly increase in a direction from wave source O toward the center of main surface S, in the group III-V compound semiconductor single crystal substrate 100. In this case, the strain (residual strain) which is generated in group III-V compound semiconductor single crystal substrate 100 and is based on the impurity atom shall be expressed in a polar coordinate which sets the center of the main surface S as the origin point, and then, the residual strain does not show a distribution that is the n-fold symmetry (where n is an integer of 2 or more) around the origin point, but shows a distribution that is only 1-fold symmetry (see Fig. 3); and accordingly, the stress of the residual strain tends to be easily released on the substrate. Thereby, the stress of the residual strain does not need to be released at the time of slicing and the like, and accordingly, it becomes possible to decrease the cracking defect rate of the substrate.

The concentration distribution of the impurity atoms can be specifically obtained according to the following method. Firstly, at each position on the main surface, at which a virtual straight line passing through the center of the main surface and extending in a direction from the wave source toward the center of the main surface overlaps with the outer periphery of the main surface on the wave source side of the center, the center of the main surface, and the outer periphery on the side opposite to the wave source with respect to the center of the main surface, the group III-V compound semiconductor single crystal substrate is cleaved along the (100) plane. Thereby, a measurement sample is prepared that has typically a square surface of which the one side is 10 mm and has a thickness of 300 to 1000 $\mu$m, and the above described GDMS is executed with the use of the measurement sample. This makes it possible to clarify what concentration distribution the impurity atoms show in the direction from the wave source toward the center of the main surface, in the group III-V compound semiconductor single crystal substrate.

[Method for Manufacturing Group III-V Compound Semiconductor Single Crystal Substrate]

It is preferable that the method for manufacturing the group III-V compound semiconductor single crystal substrate according to the present embodiment is, for example, the following manufacturing method. Specifically, the manufacturing method is a method for manufacturing the group III-V compound semiconductor single crystal substrate using a crystal growth apparatus, and includes: a step of obtaining a group III-V compound semiconductor single crystal, by bringing a seed crystal into contact with a raw material melt, and growing a crystalline solid on the raw material melt side of the seed crystal (first step); and a step of obtaining the group III-V compound semiconductor single crystal substrate having a circular main surface, by cutting out the group III-V compound semiconductor single crystal (second step). The crystal growth apparatus includes at least a cylindrical crucible, and a heating element that heats the crucible. The crucible houses the seed crystal at a bottom portion thereof, and houses the raw material melt above the seed crystal in the crucible. The interface between the crystalline solid and the raw material melt has a crossing angle of less than 90° with respect to the axis of the crucible.

The present inventors have devised, for example, a structure of the heating element as will be described later, and thereby have set the interface between the crystalline solid to be grown on the side of the raw material melt of the seed crystal and the raw material melt so as not to be horizontal as in the conventional technique, but so as to have a crossing angle of less than 90° with respect to the axis of the crucible, when growing the group III-V compound semiconductor single crystal which becomes a raw material of the group III-V compound semiconductor single crystal substrate in the crucible of the crystal growth apparatus with the use of the VB method. In this case, the present inventors have found that the cracking defect rate is decreased at the time of obtaining the group III-V compound semiconductor single crystal substrate by slicing, from a group III-V compound semiconductor single crystal formed by crystal growth, as compared with the conventional case.

In the present specification, the "cracking defect rate" refers to a rate at which the group III-V compound semiconductor single crystal substrate is cracked in a series of steps for manufacturing the group III-V compound semiconductor single crystal substrate. Specifically, the "cracking defect rate" refers to a rate at which the cracking defect such as chipping in addition to cracking occurs, in a series of steps of: obtaining a group III-V compound semiconductor single crystal substrate precursor by growing the group III-V compound semiconductor single crystal, grinding the outer periphery, forming an OF or a notch, and slicing the resultant substrate to a desired thickness; and obtaining the group III-V compound semiconductor single crystal substrate by further grinding the outer periphery of the group III-V compound semiconductor single crystal substrate precursor, and passing etching of the back surface, polishing of the front surface, and cleaning and drying. On the other hand, a "slicing yield" in the present specification shall refer to a rate at which a satisfactory group III-V compound semiconductor single crystal substrate is obtained without the occurrence of the cracking defect.

With reference to Fig. 7, one example of the method for manufacturing the group III-V compound semiconductor single crystal substrate according to the present embodiment will be described below, in which a so-called VB method with the use of a crucible is adopted, such as a vertical Bridgman method or a vertical temperature gradient solidification method, which is included in the vertical boat method. In the method for manufacturing the group III-V compound semiconductor single crystal substrate according to the present embodiment, a seed crystal charging step, a raw material charging step, a sealing agent arranging step, a crystal growth step as a first step, and a cutting step and an outer periphery grinding step as a second step are executed in this order. When the manufacturing method is executed, a crystal growth apparatus can be used which is provided with a crucible 1 and a heating element 2, for example, shown in Fig. 7. Fig. 7 is a schematic view for schematically describing the crystal growth apparatus for growing the group III-V compound semiconductor single crystal which becomes the raw material of the group III-V compound semiconductor single crystal substrate according to the present embodiment.

In the crystal growth apparatus, crucible 1 is cylindrical and includes a seed crystal retaining portion, and a crystal growing portion which is connected to the seed crystal retaining portion. The crystal growing portion further includes a conical portion and a straight body portion. The seed crystal retaining portion is a cylindrical region having a cylindrical hollow portion which is opened on the side connected to the crystal growing portion and has a bottom wall formed on the opposite side. The seed crystal retaining portion can retain a seed crystal 31 in the hollow portion. The conical portion of the crystal growing portion has a conical shape, and is connected to the seed crystal retaining portion on a small diameter side. The straight body portion has a hollow cylindrical shape and is connected to a large diameter side of the conical portion. The crystal growing portion of crucible 1 has a function of retaining a solid group III-V compound semiconductor raw material, in the inside thereof. Furthermore, the crystal growing portion of crucible 1 has a function of growing a group III-V compound semiconductor single crystal as a crystalline solid 32 by solidifying a raw material melt 33 which is a raw material heated so as to become a molten state. The crucible 1 can adopt various materials for its material, which can withstand the temperature at which the group III-V compound semiconductor raw material melts. It is convenient to adopt, for example, pyrolytic boron nitride (pBN) as the material of crucible 1. Furthermore, the crystal growth apparatus can include a crucible retaining table 4 for retaining crucible 1. As a material of crucible retaining table 4, for example, silicon carbide can be adopted.

In the crystal growth apparatus, heating element 2 is arranged so as to surround the outer periphery of the cylindrical crucible 1 with two bodies. Furthermore, each of heating elements 2 is divided into a plurality of portions in a direction perpendicular to the axis of the crucible, and thereby is structured into multiple stages. This makes it possible to control the output of heating element 2 independently for each body and each portion, and for example, to easily decrease the output of heating element 2 gradually upward along the axis of crucible 1. Furthermore, by decreasing the output of heating element 2 gradually upward along the axis of crucible 1, it becomes possible to control the interface between the crystalline solid to be grown on the raw material melt side of the seed crystal and the raw material melt so as to have a crossing angle of less than 90° with respect to the axis of crucible 1. With reference to Fig. 8, the methods for manufacturing the InP substrate and the GaAs substrate as the group III-V compound semiconductor single crystal substrate will be each described below in detail, for each step of the manufacturing method. Fig. 8 is a flowchart showing one example of a method for manufacturing the group III-V compound semiconductor single crystal substrate according to the present embodiment.

<Method for Manufacturing InP Substrate>

(Seed Crystal Charging Step S10)

In the method for manufacturing the InP substrate, a seed crystal charging step S10 is firstly executed. In seed crystal charging step S10, seed crystal 31 (InP seed crystal) is charged into the hollow portion of the seed crystal retaining portion of crucible 1. A conventionally known method can be used as the method for charging seed crystal 31 into the seed crystal retaining portion. Here, it is preferable to set the cross-sectional area of seed crystal 31 to 15% or more with respect to the cross-sectional area of the straight body portion of crucible 1, and is more preferable to set the cross-sectional area to 50% or more. It is preferable for the average dislocation density of seed crystal 31 to be 5000 cm$^{-2}$, and is more preferable to be 2000 cm$^{-2}$. It is also preferable to add a trace amount of impurity atoms (S, Sn) to seed crystal 31. Furthermore, it is preferable for the inclination angle leading to the straight body portion in the conical portion of crucible 1 to be 40° or less, and is more preferable to be 20° or less.

(Raw Material Charging Step S20)

Next, a raw material charging step S20 is executed. In raw material charging step S20, a plurality of lumps consisting of polycrystals (InP polycrystals) of the group III-V compound semiconductor raw material are charged into the crystal growing portion (conical portion and straight body portion) in crucible 1, and are stacked there. Furthermore, in the present step, it is possible to add a predetermined amount of impurity atoms (S, Sn).

(Sealing Agent Arranging Step S30)

Next, a sealing agent arranging step S30 is executed. In sealing agent arranging step S30, a sealing agent which is conventionally known in the VB method (for example, a solid sealing agent formed from $B_2O_3$ (boron oxide)) is arranged on the lumps.

(Crystal Growth Step S40: First Step)

Next, a crystal growth step S40 which is a first step is executed. Specifically, the first step functions as crystal growth step S40, and includes bringing seed crystal 31 into contact with a raw material melt 33, and growing crystalline solid 32 on raw material melt 33 side of seed crystal 31, for the purpose of obtaining the group III-V compound semiconductor single crystal (InP single crystal). Specifically, crucible 1 in which seed crystal 31, the lump that is the raw material of the III-V compound semiconductor single crystal, and the solid sealing agent are arranged in the inside is loaded on crucible retaining table 4 in the crystal growth apparatus. After that, an electric current is supplied to heating element 2, and crucible 1 is heated. As a result, the solid sealing agent is melted to become a liquid sealing agent 5, and the lump of the raw material is melted to become raw material melt 33. After that, a part of seed crystal 31 is also melted and comes into contact with raw material melt 33 at the interface. Furthermore, crucible 1 is gradually dragged down along the axis downward (seed crystal retaining portion side) with respect to heating element 2, thereby, a temperature gradient in crucible 1 is formed so that the temperature on seed crystal 31 side is low and the temperature on raw material melt 33 side is high; and raw material melt 33 in contact with seed crystal 31 is solidified, and a crystalline solid 32 is grown on raw material melt 33 side of seed crystal 31. It is preferable for a speed at which crucible 1 is dragged downward along the axis to be 10 mm/hour or less, and is more preferably to be 5 mm/hour or less. Furthermore, when crucible 1 is dragged downward along the axis, it is preferable that crucible 1 is rotated around the axis at around 5 rpm.

Here, as for heating element 2, two heating elements (one set) are arranged every half circumference so as to cover the outer periphery of crucible 1 as described above. Furthermore, the output of heating element 2 is controlled so as to decrease gradually upward along the axis of crucible 1. Thereby, in the first step, when crystalline solid 32 is grown on raw material melt 33 side of seed crystal 31, an interface 3a between crystalline solid 32 and raw material melt 33 does not become horizontal, but has a crossing angle of less than 90° with respect to the axis of crucible 1. For example, it is preferable that interface 3a has a crossing angle of 10 to 70° with respect to the axis of crucible 1.

In the first step, crucible 1 is subsequently dragged downward along the axis with respect to heating element 2, and interface 3a between crystalline solid 32 and raw material melt 33, which is not horizontal, is raised toward a liquid sealing agent 5 side; and thereby raw material melt 33 is solidified, and crystalline solid 32 can be grown upward along the axis of crucible 1. The growth of crystalline solid 32 is continued until the solidification of raw material melt 33 is completed which remains in the crystal growing portion of crucible 1. This makes it possible to obtain the group III-V compound semiconductor single crystal (InP single crystal) composed of crystalline solid 32.

(Cutting Step and Outer Periphery Grinding Step S50: Second Step)

The cutting step is a step of cutting out the group III-V compound semiconductor crystal (InP single crystal) which has been taken out from crucible 1, and thereby, obtaining the group III-V compound semiconductor substrate precursor. Furthermore, the outer periphery grinding step is a step of grinding the outer periphery of the group III-V compound semiconductor substrate precursor, and thereby, obtaining the group III-V compound semiconductor substrate (InP substrate) having the circular main surface. In other words, a cutting step and outer periphery grinding step S50 (second step) are steps of executing slicing on the InP single crystal. Cutting step and outer periphery grinding step S50 can be executed by using a conventionally known cutting method and a conventionally known outer periphery grinding method, respectively, in the method for manufacturing the InP substrate with the use of the VB method.

<Method for Manufacturing GaAs Substrate>

(Seed Crystal Charging Step S10)

In the method for manufacturing the GaAs substrate, seed crystal charging step S10 is firstly executed. In seed crystal charging step S10, seed crystal 31 (GaAs seed crystal) is charged into the hollow portion of the seed crystal retaining portion of crucible 1. A conventionally known method can be used as the method for charging seed crystal 31 into the seed crystal retaining portion.

(Raw Material Charging Step S20)

Next, a raw material charging step S20 is executed. In raw material charging step S20, a plurality of lumps consisting of polycrystals (GaAs polycrystals) of the group III-V compound semiconductor raw material are charged into the crystal growing portion (conical portion and straight body portion) in crucible 1, and are stacked there. Furthermore, in the present step, it is possible to add a predetermined amount of impurity atoms (Si).

(Sealing Agent Arranging Step S30)

Next, a sealing agent arranging step S30 is executed. In sealing agent arranging step S30, a sealing agent which is conventionally known in the VB method (for example, solid sealing agent formed from $B_2O_3$ (boron oxide)) is arranged on the lumps.

(Crystal Growth Step S40: First Step)

Next, a crystal growth step S40 which is a first step is executed. Specifically, the first step functions as a crystal growth step S40, and includes bringing seed crystal 31 into contact with a raw material melt 33, and growing crystalline solid 32 on raw material melt 33 side of seed crystal 31, for the purpose of obtaining the group III-V compound semiconductor single crystal (GaAs single crystal). Specifically, crucible 1 in which seed crystal 31, the lump that is the raw material of the group III-V compound semiconductor single crystal, and the solid sealing agent are arranged in the inside is loaded on crucible retaining table 4 in the crystal growth apparatus. After that, an electric current is supplied to heating element 2, and crucible 1 is heated. As a result, the solid sealing agent is melted to become a liquid sealing agent 5, and the lump of the raw material is melted to become raw material melt 33. Subsequently, a part of seed crystal 31 is also melted and comes into contact with raw material melt 33 at the interface. Furthermore, crucible 1 is gradually dragged down along the axis downward (seed crystal retaining portion side) with respect to heating element 2, thereby, a temperature gradient in crucible 1 is formed so that the temperature on seed crystal 31 side is low and the temperature on raw material melt 33 side is high; and raw material melt 33 in contact with seed crystal 31 is solidified, and a crystalline solid 32 is grown on raw material melt 33 side of seed crystal 31. The speed at which crucible 1 is dragged downward along the axis is not particularly limited, and can be set to, for example, 2 to 10 mm/hour.

As for heating element 2, two heating elements (one set) are arranged every half circumference so as to cover the outer periphery of crucible 1, as described above. Furthermore, the output of heating element 2 is controlled so as to decrease gradually upward along the axis of crucible 1. Thereby, in the first step, when crystalline solid 32 is grown on raw material melt 33 side of seed crystal 31, interface 3a between crystalline solid 32 and raw material melt 33 does not become horizontal, but has a crossing angle of less than 90° with respect to the axis of crucible 1. For example, it is preferable that interface 3a has a crossing angle of 10 to 70° with respect to the axis of crucible 1.

In the first step, crucible 1 is subsequently dragged downward along the axis with respect to heating element 2, and interface 3a between crystalline solid 32 and raw material melt 33, which is not horizontal, is raised toward liquid sealing agent 5 side; and thereby raw material melt 33 is solidified, and crystalline solid 32 can be grown upward along the axis of crucible 1. The growth of crystalline solid 32 is continued until the solidification of raw material melt 33 is completed which remains in the crystal growing portion of crucible 1. This makes it possible to obtain the group III-V compound semiconductor single crystal (GaAs single crystal) composed of crystalline solid 32.

(Cutting Step and Outer Periphery Grinding Step S50: Second Step)

The cutting step is a step of cutting out the group III-V compound semiconductor crystal (GaAs single crystal) which has been taken out from crucible 1, and thereby, obtaining the group III-V compound semiconductor substrate precursor. Furthermore, the outer periphery grinding step is a step of grinding the outer periphery of the group III-V compound semiconductor substrate precursor, and thereby, obtaining the group III-V compound semiconductor substrate (GaAs substrate) having the circular main surface. In other words, a cutting step and outer periphery grinding step S50 (second step) is a step of executing slicing on the GaAs single crystal. Cutting step and outer periphery grinding step S50 can be executed by using a conventionally known cutting method and a conventionally known outer periphery grinding method, respectively, in the method for manufacturing the GaAs substrate with the use of the VB method.

<Action and Effect>

Due to the above steps being executed, it becomes possible to manufacture the group III-V compound semiconductor single crystal substrate having the circular main surface. The method for manufacturing the group III-V compound semiconductor single crystal substrate according to the present embodiment forms interface 3a between crystalline solid 32 and raw material melt 33 so as to have a crossing angle of less than 90° with respect to the axis of crucible 1, especially in the first step, and grows crystalline solid 32 on raw material melt 33 side of seed crystal 31. Thereby, the cracking defect rate of the group III-V compound semiconductor single crystal substrate decreases at the time of slicing which is executed in the second step. Accordingly, due to the above manufacturing method, it becomes possible to obtain the group III-V compound semiconductor single crystal substrate in which the cracking defect rate is decreased.

In the above manufacturing method, it is preferable that a growth direction of the group III-V compound semiconductor single crystal (crystalline solid 32) is the <100> direction. Furthermore, the group III-V compound semiconductor single crystal substrate according to the present embodiment is preferably obtained by cutting out the {100} just plane as the main surface from the group III-V compound semiconductor single crystal. Furthermore, it is possible to obtain the group III-V compound semiconductor single crystal substrate having the above described main surface which has an off angle of more than 0° and 15° or less from the {100} plane, by executing inclined slicing from a group III-V compound semiconductor single crystal of which the growth direction is controlled to be the <100> direction, with the use of a conventionally known method.

Examples

Hereinafter, the present disclosure will be described in more detail with reference to Examples, but the present disclosure is not limited thereto. In the Examples described later, a group III-V compound semiconductor single crystal was grown having the <100> direction as a growth direction, by using a crystal growth apparatus shown in Fig. 7 and using the VB method, thereby, InP substrates (Examples 1 to 8) were obtained each having a main surface in which a plane orientation was the (100) just plane, and GaAs substrates (Examples 11 to 17) were obtained each having the main surface in which the plane orientation was a plane having an off angle of 0 to 15° with respect to the (100) plane. On the other hand, in Comparative Examples described later, group III-V compound semiconductor crystals (InP substrate and GaAs substrate) were grown by using a conventional crystal growth apparatus including a heating element arranged so as to cover the whole circumference of the side surface of the crucible. In each of the Examples and Comparative Examples, 1000 sheets of InP substrates or GaAs substrates were manufactured.

<<First Test>>

[Manufacture of Group III-V Compound Semiconductor Single Crystal Substrate]

<Example 1: InP Substrate>

(Seed Crystal Charging Step S10)

A seed crystal 31 formed from InP, which was manufactured by a conventionally known method, was charged into a hollow portion of a seed crystal retaining portion of a crucible 1 which is provided in the crystal growth apparatus, by using a conventionally known method. A trace amount of tin (Sn) was added to seed crystal 31 as an impurity element. The cross-sectional area of seed crystal 31 was set to 50% of the cross-sectional area of the straight body portion of crucible 1. Furthermore, the inclination angle of the conical portion of crucible 1 leading to the straight body portion was set to 20°.

(Raw Material Charging Step S20 and Sealing Agent Arranging Step S30)

A plurality of lumps formed of polycrystalline InP were charged into the crystal growing portion of crucible 1, and were stacked there. A predetermined amount of tin (Sn) was also added. Furthermore, a solid sealing agent formed of $B_2O_3$ was then arranged on the lump of the raw material. An inner diameter of the crystal growing portion of crucible 1 was 60 mm, which was used in the present Example.

(Crystal Growth Step S40: First Step)

An electric current was supplied to a heating element 2 to heat crucible 1, thereby, the solid sealing agent was converted into a liquid sealing agent 5, and the lump in crucible 1 was converted into a raw material melt 33. Furthermore, a part of seed crystal 31, and the lump positioned at the interface with seed crystal 31 were also brought into contact with each other as raw material melt 33. Next, crucible 1 was dragged downward along an axis thereof (toward seed crystal retaining portion side) with respect to heating element 2, thereby growing a crystalline solid 32 on a raw material melt 33 side of seed crystal 31.

Here, heating element 2 is arranged so as to surround the outer periphery of cylindrical crucible 1 with two bodies as described above. Furthermore, each of heating elements 2 is divided into a plurality of portions in a direction perpendicular to the axis of crucible 1, and thereby is structured into multiple stages. With such a configuration, the output of heating element 2 was gradually decreased upward along the axis of crucible 1. Thereby, in the first step, an interface 3a between crystalline solid 32 and raw material melt 33 was controlled so as to have a crossing angle of 30° with respect to the axis of crucible 1.

Subsequently, heating element 2 was dragged downward along the axis of crucible 1, thereby, interface 3a between crystalline solid 32 and raw material melt 33 was raised upward along the axis of crucible 1, and crystalline solid 32 was grown upward along the axis of crucible 1. This was continued until the solidification of raw material melt 33 was completed which remained in the crystal growing portion of crucible 1. In this way, the InP single crystal was manufactured in crucible 1. After that, the InP single crystal was taken out from crucible 1 with the use of a conventionally known method.

(Cutting Step and Outer Periphery Grinding Step S50: Second Step)

An InP substrate precursor was obtained by cutting out the InP single crystal taken out from crucible 1 by using a conventionally known cutting method and outer periphery grinding method, and the InP substrate having a circular main surface was manufactured by grinding the outer periphery of the InP substrate precursor. In this way, the InP substrate was obtained as Example 1, of which the diameter was 50 mm and the thickness was 350 $\mu$m.

<Example 2: InP Substrate>

An InP substrate was obtained of which the diameter was 50 mm and the thickness was 350 $\mu$m by using the same method as in Example 1, except that a seed crystal 31 to which a trace amount of sulfur (S) was added in a seed crystal charging step was prepared. In the crystal growth step (first step) of Example 2, interface 3a between crystalline solid 32 to be grown in crucible 1 and raw material melt 33 had a crossing angle of 30° with respect to the axis of crucible 1.

<Example 3: InP Substrate>

An InP substrate was obtained of which the diameter was 75 mm and the thickness was 600 $\mu$m by using the same method as in Example 1, except that the inner diameter of the crystal growing portion in crucible 1 of the crystal growth apparatus was set to 85 mm. In the crystal growth step (first step) of Example 3, interface 3a between crystalline solid 32 to be grown in crucible 1 and raw material melt 33 had a crossing angle of 30° with respect to the axis of crucible 1.

<Example 4: InP Substrate>

An InP substrate was obtained of which the diameter was 75 mm and the thickness was 600 $\mu$m by using the same method as in Example 2, except that the inner diameter of the crystal growing portion in crucible 1 of the crystal growth apparatus was set to 85 mm. In the crystal growth step (first step) of Example 4, interface 3a between crystalline solid 32 to be grown in crucible 1 and raw material melt 33 had a crossing angle of 30° with respect to the axis of crucible 1.

<Example 5: InP Substrate>

An InP substrate was obtained of which the diameter was 100 mm and the thickness was 625 $\mu$m by using the same method as in Example 1, except that the inner diameter of the crystal growing portion in crucible 1 of the crystal growth apparatus was set to 110 mm. In the crystal growth step (first step) of Example 5, interface 3a between crystalline solid 32 to be grown in crucible 1 and raw material melt 33 had a crossing angle of 30° with respect to the axis of crucible 1.

<Example 6: InP Substrate>

An InP substrate was obtained of which the diameter was 100 mm and the thickness was 625 $\mu$m by using the same method as in Example 2, except that the inner diameter of the crystal growing portion in crucible 1 of the crystal growth apparatus was set to 110 mm. In the crystal growth step (first step) of Example 6, interface 3a between crystalline solid 32 to be grown in crucible 1 and raw material melt 33 had a crossing angle of 30° with respect to the axis of crucible 1.

<Example 7: InP Substrate>

An InP substrate was obtained of which the diameter was 150 mm and the thickness was 675 $\mu$m by using the same method as in Example 1, except that the inner diameter of the crystal growing portion in crucible 1 of the crystal growth apparatus was set to 160 mm. In the crystal growth step (first step) of Example 7, interface 3a between crystalline solid 32 to be grown in crucible 1 and raw material melt 33 had a crossing angle of 30° with respect to the axis of crucible 1.

<Example 8: InP Substrate>

An InP substrate was obtained of which the diameter was 150 mm and the thickness was 675 $\mu$m by using the same method as in Example 2, except that the inner diameter of the crystal growing portion in crucible 1 of the crystal growth apparatus was set to 160 mm. In the crystal growth step (first step) of Example 8, interface 3a between crystalline solid 32 to be grown in crucible 1 and raw material melt 33 had a crossing angle of 30° with respect to the axis of crucible 1.

<Comparative Example 1: InP Substrate>

An InP substrate was obtained of which the diameter was 50 mm and the thickness was 350 $\mu$m by using the same method as in Example 1, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 2: InP Substrate>

An InP substrate was obtained of which the diameter was 50 mm and the thickness was 350 $\mu$m by using the same method as in Example 2, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 3: InP Substrate>

An InP substrate was obtained of which the diameter was 75 mm and the thickness was 600 $\mu$m by using the same method as in Comparative Example 1, except that the inner diameter of the crystal growing portion in crucible 1 of the crystal growth apparatus was set to 85 mm.

<Comparative Example 4: InP Substrate>

An InP substrate was obtained of which the diameter was 75 mm and the thickness was 600 $\mu$m by using the same method as in Comparative Example 2, except that the inner diameter of the crystal growing portion in crucible 1 of the crystal growth apparatus was set to 85 mm.

<Comparative Example 5: InP Substrate>

An InP substrate was obtained of which the diameter was 100 mm and the thickness was 625 $\mu$m by using the same method as in Comparative Example 1, except that the inner diameter of the crystal growing portion in crucible 1 of the crystal growth apparatus was set to 110 mm.

<Comparative Example 6: InP Substrate>

An InP substrate was obtained of which the diameter was 100 mm and the thickness was 625 $\mu$m by using the same method as in Comparative Example 2, except that the inner diameter of the crystal growing portion in crucible 1 of the crystal growth apparatus was set to 110 mm.

<Comparative Example 7: InP Substrate>

An InP substrate was obtained of which the diameter was 150 mm and the thickness was 675 $\mu$m by using the same method as in Comparative Example 1, except that the inner diameter of the crystal growing portion in crucible 1 of the crystal growth apparatus was set to 160 mm.

<Comparative Example 8: InP Substrate>

An InP substrate was obtained of which the diameter was 150 mm and the thickness was 675 $\mu$m by using the same method as in Comparative Example 2, except that the inner diameter of the crystal growing portion in crucible 1 of the crystal growth apparatus was set to 160 mm.

<Example 11: GaAs Substrate>

(Seed Crystal Charging Step S10)

A seed crystal 31 formed from GaAs, which was manufactured by a conventionally known method, was charged into a hollow portion of the seed crystal retaining portion of crucible 1, which was provided in the crystal growth apparatus, by using a conventionally known method. A trace amount of silicon (Si) was added to seed crystal 31 as an impurity element.

(Raw Material Charging Step S20 and Sealing Agent Arranging Step S30)

A plurality of lumps formed of polycrystalline GaAs were charged into the crystal growing portion of crucible 1, and were stacked there. A predetermined amount of Si was also added. Furthermore, a solid sealing agent formed of $B_2O_3$ was then arranged on the lump of the raw material. An inner diameter of the crystal growing portion of crucible 1 was 80 mm, which was used in the present Example.

(Crystal Growth Step S40: First Step)

An electric current was supplied to heating element 2 to heat crucible 1, thereby, the solid sealing agent was converted into a liquid sealing agent 5, and the lump in crucible 1 was converted into a raw material melt 33. Furthermore, a part of seed crystal 31, and the lump positioned at the interface with seed crystal 31 were also brought into contact with each other as raw material melt 33. Next, crucible 1 was dragged downward along an axis thereof (toward seed crystal retaining portion side) with respect to heating element 2, thereby growing a crystalline solid 32 on raw material melt 33 side of seed crystal 31.

Here, heating element 2 is arranged so as to surround the outer periphery of cylindrical crucible 1 with two bodies as described above. Furthermore, each of heating elements 2 is divided into a plurality of portions in a direction perpendicular to the axis of crucible 1, and thereby is structured into multiple stages. With such a configuration, the output of heating element 2 was gradually decreased upward along the axis of crucible 1. Thereby, in the first step, an interface 3a between crystalline solid 32 and raw material melt 33 was controlled so as to have a crossing angle of 30° with respect to the axis of crucible 1.

Subsequently, heating element 2 was dragged downward along the axis of crucible 1, thereby, interface 3a between crystalline solid 32 and raw material melt 33 was raised upward along the axis of crucible 1, and crystalline solid 32 was grown upward along the axis of crucible 1. This was continued until the solidification of raw material melt 33 was completed which remained in the crystal growing portion of crucible 1. In this way, the GaAs single crystal was manufactured in crucible 1. After that, the GaAs single crystal was taken out from crucible 1 with the use of a conventionally known method.

(Cutting Step and Outer Periphery Grinding Step S50: Second Step)

By using a conventionally known cutting method and outer periphery grinding method, a GaAs substrate precursor was obtained by cutting out the GaAs anti-crystal taken out from crucible 1 so that the main surface becomes a plane having a (100) just plane with the use of a known slicing method, and a GaAs substrate having the circular main surface was manufactured by grinding the outer periphery of the GaAs substrate precursor. In this way, the GaAs substrate was obtained as Example 11, of which the diameter was 75 mm and the thickness was 600 μm.

<Example 12: GaAs Substrate>

A GaAs substrate was obtained of which the diameter was 75 mm and the thickness was 600 μm by using the same method as in Example 11, except that the GaAs substrate precursor was obtained by cutting out the GaAs single crystal taken out from crucible 1 so that the main surface becomes a plane having an off angle of 10° from the (100) plane, in the cutting step and the outer periphery grinding step (second step). In the crystal growth step (first step) of Example 12, interface 3a between crystalline solid 32 to be grown in crucible 1 and raw material melt 33 had a crossing angle of 30° with respect to the axis of crucible 1.

<Example 13: GaAs Substrate>

A GaAs substrate was obtained of which the diameter was 100 mm and the thickness was 625 μm by using the same method as in Example 11, except that the inner diameter of the crystal growing portion in crucible 1 of the crystal growth apparatus was set to 110 mm. In the crystal growth step (first step) of Example 13, interface 3a between crystalline solid 32 to be grown in crucible 1 and raw material melt 33 had a crossing angle of 30° with respect to the axis of crucible 1.

<Example 14: GaAs Substrate>

A GaAs substrate was obtained of which the diameter was 150 mm and the thickness was 760 μm by using the same method as in Example 11, except that the inner diameter of the crystal growing portion in crucible 1 of the crystal growth apparatus was set to 160 mm and the GaAs single crystal taken out from crucible 1 was cut out so that the main surface becomes a plane having an off angle of 2° from the (100) plane, in cutting step and outer periphery grinding step S50. In the crystal growth step (first step) of Example 14, interface 3a between crystalline solid 32 to be grown in crucible 1 and raw material melt 33 had a crossing angle of 30° with respect to the axis of crucible 1.

<Example 15: GaAs Substrate>

A GaAs substrate was obtained of which the diameter was 150 mm and the thickness was 760 μm by using the same method as in Example 11, except that the inner diameter of the crystal growing portion in crucible 1 of the crystal growth apparatus was set to 160 mm and the GaAs single crystal taken out from crucible 1 was cut out so that the main surface becomes a plane having an off angle of 6° from the (100) plane, in cutting step and outer periphery grinding step S50. In the crystal growth step (first step) of Example 15, interface 3a between crystalline solid 32 to be grown in crucible 1 and raw material melt 33 had a crossing angle of 30° with respect to the axis of crucible 1.

<Example 16: GaAs Substrate>

A GaAs substrate was obtained of which the diameter was 150 mm and the thickness was 760 μm by using the same method as in Example 11, except that the inner diameter of the crystal growing portion in crucible 1 of the crystal growth apparatus was set to 160 mm and the GaAs single crystal taken out from crucible 1 was cut out so that the main surface became a plane having an off angle of 15° from the (100) plane, in cutting step and outer periphery grinding step S50. In the crystal growth step (first step) of Example 16, interface 3a between crystalline solid 32 to be grown in crucible 1 and raw material melt 33 had a crossing angle of 30° with respect to the axis of crucible 1.

<Example 17: GaAs Substrate>

A GaAs substrate was obtained of which the diameter was 200 mm and the thickness was 675 μm by using the same method as in Example 11, except that the inner diameter of the crystal growing portion in crucible 1 of the crystal growth apparatus was set to 210 mm and the GaAs single crystal taken out from crucible 1 was cut out so that the main surface becomes a plane having an off angle of 6° from the (100) plane, in cutting step and outer periphery grinding step S50. In the crystal growth step (first step) of Example 17, interface 3a between crystalline solid 32 to be grown in crucible 1 and raw material melt 33 had a crossing angle of 30° with respect to the axis of crucible 1.

<Comparative Example 11: GaAs Substrate>

A GaAs substrate was obtained of which the diameter was 75 mm and the thickness was 600 μm by using the same method as in Example 11, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 12: GaAs Substrate>

A GaAs substrate was obtained of which the diameter was 75 mm and the thickness was 600 μm by using the same method as in Example 12, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 13: GaAs Substrate>

A GaAs substrate was obtained of which the diameter was 100 mm and the thickness was 625 μm by using the same method as in Example 13, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 14: GaAs Substrate>

A GaAs substrate was obtained of which the diameter was 150 mm and the thickness was 760 μm by using the same method as in Example 14, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 15: GaAs Substrate>

A GaAs substrate was obtained of which the diameter was 150 mm and the thickness was 760 $\mu$m by using the same method as in Example 15, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 16: GaAs Substrate>

A GaAs substrate was obtained of which the diameter was 150 mm and the thickness was 760 $\mu$m by using the same method as in Example 16, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

<Comparative Example 17: GaAs Substrate>

A GaAs substrate was obtained of which the diameter was 200 mm and the thickness was 675 $\mu$m by using the same method as in Example 17, except that by using a conventional crystal growth apparatus, interface 3a between crystalline solid 32 to be grown in crucible 1 and raw material melt 33 in the crystal growth step (first step) was set to have a crossing angle of 90° with respect to the axis of crucible 1 (specifically, to be horizontal).

[Evaluation of Group III-V Compound Semiconductor Single Crystal]

For each of the group III-V compound semiconductor single crystal substrates of Examples 1 to 8, Examples 11 to 17, Comparative Examples 1 to 8, and Comparative Examples 11 to 17, an average concentration of impurity atoms in the substrate, a dislocation density of the main surface, and a degree of asymmetry of dislocations existing in the main surface were determined according to the above described method. Furthermore, the average value of the residual strain and the pattern of the distribution of the residual strain in the polar coordinate (whether or not the distribution is n-fold symmetric, and further whether or not the distribution is mirror symmetric (including the case of approximate mirror symmetry)) are determined by the above described method, and it was also determined whether or not the wave source of the ripple-like pattern visually recognized on the main surface was positioned on the main surface, according to the above described method. The results are shown in Table 1 to Table 4.

Furthermore, a rate of substrates that were obtained as satisfactory group III-V compound semiconductor single crystal substrates because of not causing cracking, chipping, or the like was determined as the "slicing yield", when 1000 sheets of the group III-V compound semiconductor single crystal substrates were manufactured for each of Examples 1 to 8, Examples 11 to 17, Comparative Examples 1 to 8, and Comparative Examples 11 to 17. The results are also shown in Table 1 to Table 4. The "slicing yield" in Table 1 to Table 4 was evaluated as being satisfactory in the case where the yield was 90% or more, and was evaluated as being not satisfactory when the yield was less than 90%.

[Table 1]

Table. 1

| | | Example 1 | Example 2 | Example 3 | Example 4 | Example 5 | Example 6 | Example 7 | Example 8 |
|---|---|---|---|---|---|---|---|---|---|
| Diameter [mm] | | 50 | 50 | 75 | 75 | 100 | 100 | 150 | 150 |
| Thickness [$\mu$m] | | 350 | 350 | 600 | 600 | 625 | 625 | 675 | 675 |
| Crystal orientation of main surface | | (100) | (100) | (100) | (100) | (100) | (100) | (100) | (100) |
| Dopant | | Sn | S | Sn | S | Sn | S | Sn | S |
| Dopant concentration [/cm$^3$] | | $1.0\times10^{18}$ | $3.0\times10^{18}$ | $1.0\times10^{18}$ | $3.0\times10^{18}$ | $1.0\times10^{18}$ | $3.0\times10^{18}$ | $1.0\times10^{18}$ | $3.0\times10^{18}$ |
| Dislocation density | In-plane 69 points Average value [/cm$^2$] | 900 | 100 | 1200 | 110 | 1500 | 130 | 1800 | 200 |
| | Degree of asymmetry | 1.8 | 1.9 | 1.8 | 2.0 | 2.2 | 2.6 | 2.4 | 2.5 |
| Residual strain | \|Sr-St\| Average value | $5.8\times10^{-6}$ | $5.0\times10^{-6}$ | $1.0\times10^{-5}$ | $9.4\times10^{-6}$ | $2.1\times10^{-5}$ | $1.8\times10^{-5}$ | $3.0\times10^{-5}$ | $3.0\times10^{-5}$ |
| | Pattern | Approximate mirror symmetry | Approximate mirror symmetry | Approximate mirror symmetry | Approximate mirror symmetry | Approximate mirror symmetry | Approximate mirror symmetry | Approximate mirror symmetry | Approximate mirror symmetry |
| Ripple-like pattern | Wave source position | Outside substrate | Outside substrate | Outside substrate | Outside substrate | Outside substrate | Outside substrate | Outside substrate | Outside substrate |
| Slicing yield (%) | | 98.8 | 98.8 | 98.5 | 98.6 | 98.2 | 98.1 | 97.6 | 97.8 |

[Table 2]

[Table 2]

Table. 2

| | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|
| Diameter [mm] | | 50 | 50 | 75 | 75 | 100 | 100 | 150 | 150 |
| Thickness [$\mu$m] | | 350 | 350 | 600 | 600 | 625 | 625 | 675 | 675 |
| Crystal orientation of main surface | | (100) | (100) | (100) | (100) | (100) | (100) | (100) | (100) |
| Dopant | | Sn | S | Sn | S | Sn | S | Sn | S |
| Dopant concentration [/cm$^3$] | | $1.0\times10^{18}$ | $3.0\times10^{18}$ | $1.0\times10^{18}$ | $3.0\times10^{18}$ | $1.0\times10^{18}$ | $3.0\times10^{18}$ | $1.0\times10^{18}$ | $3.0\times10^{18}$ |
| Dislocation density | In-plane 69 points Average value [/cm$^2$] | 1200 | 300 | 2100 | 450 | 2200 | 700 | 3400 | 800 |
| | Degree of asymmetry | 1.2 | 1.1 | 1.3 | 1.4 | 1.3 | 1.5 | 1.4 | 1.6 |
| Residual strain | \|Sr-St\| Average value | $6.0\times10^{-6}$ | $5.5\times10^{-6}$ | $1.2\times10^{-5}$ | $1.0\times10^{-5}$ | $2.3\times10^{-5}$ | $2.1\times10^{-5}$ | $4.0\times10^{-5}$ | $3.5\times10^{-5}$ |
| | Pattern | Four-fold symmetry | Four-fold symmetry | Four-fold symmetry | Four-fold symmetry | Four-fold symmetry | Four-fold symmetry | Four-fold symmetry | Four-fold symmetry |
| Ripple-like pattern | Wave source position | Within substrate | Within substrate | Within substrate | Within substrate | Within substrate | Within substrate | Within substrate | Within substrate |
| Slicing yield (%) | | 89.1 | 89.3 | 88.7 | 89.1 | 87.4 | 87.3 | 85.8 | 86.5 |

[Table 3]

[Table 3]

Table. 3

| | | Example 11 | Example 12 | Example 13 | Example 14 | Example 15 | Example 16 | Example 17 |
|---|---|---|---|---|---|---|---|---|
| Diameter [mm] | | 75 | 75 | 100 | 150 | 150 | 150 | 200 |
| Thickness [μm] | | 600 | 600 | 625 | 760 | 760 | 760 | 675 |
| Crystal orientation of main surface | | (100) | (100) | (100) | (100) | (100) | (100) | (100) |
| Off angle of main surface (°) | | 0 | 10 | 0 | 2 | 6 | 15 | 6 |
| Conductivity type | | J n-Type | n-Type | n-Type | n-Type | n-Type | n-Type | n-Type |
| Dopant | | Si | Si | Si | Si | Si | Si | Si |
| Dopant concentration [/cm³] | | $1.8 \times 10^{18}$ | $1.8 \times 10^{18}$ | $1.8 \times 10^{18}$ | $1.8 \times 10^{18}$ | $1.8 \times 10^{18}$ | $1.8 \times 10^{18}$ | $1.8 \times 10^{18}$ |
| Dislocation density | In-plane 69 points Average value [/cm²] | 20 | 10 | 20 | 30 | 20 | 10 | 50 |
| | Degree of asymmetry | 2.0 | 2.1 | 2.3 | 2.4 | 2.4 | 2.7 | 2.7 |
| | \|Sr-St\| Average value | $8.2 \times 10^{-6}$ | $7.4 \times 10^{-6}$ | $9.0 \times 10^{-6}$ | $2.0 \times 10^{-5}$ | $1.7 \times 10^{-5}$ | $1.5 \times 10^{-5}$ | $3.5 \times 10^{-5}$ |
| Residual strain | Pattern | Approximate mirror symmetry | Approximate mirror symmetry | Approximate mirror symmetry | Approximate mirror symmetry | Approximate mirror symmetry | Approximate mirror symmetry | Approximate mirror symmetry |
| Ripple-like pattern | Wave source position | Outside substrate | Outside substrate | Outside substrate | Outside substrate | Outside substrate | Outside substrate | Outside substrate |
| Slicing yield (%) | | 97.8 | 99.2 | 96.7 | 94.2 | 95.9 | 95.7 | 94.2 |

[Table 4]

[Table 4]

Table. 4

| | | Comparative Example 11 | Comparative Example 12 | Comparative Example 13 | Comparative Example 14 | Comparative Example 15 | Comparative Example 16 | Comparative Example 17 |
|---|---|---|---|---|---|---|---|---|
| Diameter [mm] | | 75 | 75 | 100 | 150 | 150 | 150 | 200 |
| Thickness [$\mu$m] | | 600 | 600 | 625 | 760 | 760 | 760 | 675 |
| Crystal orientation of main surface | | (100) | (100) | (100) | (100) | (100) | (100) | (100) |
| Off angle of main surface (°) | | 0 | 10 | 0 | 2 | 6 | 15 | 6 |
| Conductivity type | | n-Type | n-Type | n-Type | n-Type | n-Type | n-Type | n-Type |
| Dopant | | Si | Si | Si | Si | Si | Si | Si |
| Dopant concentration [/cm$^3$] | | $1.8\times10^{18}$ | $1.8\times10^{18}$ | $1.8\times10^{18}$ | $1.8\times10^{18}$ | $1.8\times10^{18}$ | $1.8\times10^{18}$ | $1.8\times10^{18}$ |
| Dislocation density | In-plane 69 points Average value [/cm$^2$] | 40 | 30 | 40 | 50 | 70 | 90 | 100 |
| | Degree of asymmetry | 1.5 | 1.6 | 1.4 | 1.9 | 1.8 | 1.7 | 1.5 |
| Residual strain | \|Sr-St\| Average value | $9.7\times10^{-6}$ | $8.9\times10^{-6}$ | $1.1\times10^{-5}$ | $3.8\times10^{-5}$ | $2.5\times10^{-5}$ | $2.3\times10^{-5}$ | $5.0\times10$-5 |
| | Pattern | Four-fold symmetry | Four-fold symmetry | Four-fold symmetry | Four-fold symmetry | Four-fold symmetry | Four-fold symmetry | Four-fold symmetry |
| Ripple-like pattern | Wave source position | Within substrate | Within substrate | Within substrate | Within substrate | Within substrate | Within substrate | Within substrate |
| Slicing yield (%) | | 89.3 | 89.1 | 88.0 | 85.4 | 86.9 | 86.7 | 85.5 |

32

EP 4 516 975 A1

[Discussion]

According to Table 1 to Table 4, in each of the group III-V compound semiconductor single crystal substrates of Example 1 to Example 8 and Example 11 to Example 17, the wave source of the ripple-like pattern formed on the main surface is not positioned on the main surface, and in this case, the "slicing yield" was 90% or more, and could be evaluated as satisfactory. On the other hand, in each of the group III-V compound semiconductor single crystal substrates of Comparative Example 1 to Comparative Example 8 and Comparative Example 11 to Comparative Example 17, the wave source of the ripple-like pattern formed on the main surface is positioned on the main surface, and in this case, the "slicing yield" was less than 90% and could not be evaluated as satisfactory.

<<Second Test>>

A concentration distribution of impurity atoms (S) on the main surface of each of the group III-V compound semiconductor single crystal substrates (InP substrates) of Example 4, Example 6, Comparative Example 4 and Comparative Example 6 was measured according to the above described method. The results are shown in Table 5. In Table 5, the impurity atom (S) concentration shown in the item "wave source side" means a concentration measured in a measurement sample that was obtained from a position on the main surface at which a virtual straight line passing through the center of the main surface and extending in a direction from the wave source toward the center of the main surface overlaps with the outer periphery closer to the wave source side than the center of the main surface. The impurity atom (S) concentration shown in the item "center" means a concentration measured in a measurement sample that was obtained from the center of the main surface, and the impurity atom (S) concentration shown in the item "ripple spreading side" means a concentration measured in a measurement sample obtained from a position on the main surface at which a virtual straight line passing through the center of the main surface and extending in a direction from the wave source toward the center of the main surface overlaps with the outer periphery on the side opposite to the wave source with respect to the center of the main surface.

[Table 5]

Table. 5

| Impurity atom (S) concentration | Wave source side | Center | Ripple spreading side |
|---|---|---|---|
| Example 4 (3 inches) | $2.9 \times 10^{18}$ | $3.0 \times 10^{18}$ | $3.1 \times 10^{18}$ |
| Example 6 (4 inches) | $2.8 \times 10^{18}$ | $3.0 \times 10^{18}$ | $3.2 \times 10^{18}$ |
| Comparative Example 4 (3 inches) | $3.0 \times 10^{18}$ | $3.0 \times 10^{18}$ | $3.0 \times 10^{18}$ |
| Comparative Example 6 (4 inches) | $3.1 \times 10^{18}$ | $3.0 \times 10^{18}$ | $3.1 \times 10^{18}$ |

[Discussion]

According to Table 5, the impurity atoms existing in the InP substrates of Example 4 and Example 6 uniformly increased in the direction from the wave source toward the center of the main surface, in other words, from the "wave source side" to the "ripple spreading side", and accordingly, the "ripple spreading side" showed a higher concentration distribution than the "wave source side". On the other hand, the impurity atoms existing in each of the InP substrates of Comparative Example 4 and Comparative Example 6 showed a distribution in which the concentration was equivalent on the "wave source side" and the "ripple spreading side".

<<Third Test>>

A concentration distribution of impurity atoms (Si) on the main surface of each of the group III-V compound semiconductor single crystal substrates (GaAs substrates) of Example 13, Example 15, Comparative Example 13 and Comparative Example 15 was measured according to the above described method. The results are shown in Table 6. In Table 6, the impurity atom (Si) concentration shown in the item "wave source side" means a concentration measured in a measurement sample that was obtained from a position on the main surface at which a virtual straight line passing through the center of the main surface and extending in a direction from the wave source toward the center of the main surface overlaps with the outer periphery closer to the wave source side than the center of the main surface. The impurity atom (Si)

EP 4 516 975 A1

concentration shown in the item "center" means a concentration measured in a measurement sample that was obtained from the center of the main surface, and the impurity atom (Si) concentration shown in the item "ripple spreading side" means a concentration measured in a measurement sample obtained from a position on the main surface at which a virtual straight line passing through the center of the main surface and extending in a direction from the wave source toward the center of the main surface overlaps with the outer periphery on the side opposite to the wave source with respect to the center of the main surface.

[Table 6]

Table. 6

| Impurity atom (Si) concentration | Wave source side | Center | Ripple spreading side |
|---|---|---|---|
| Example 13 (4 inches) | $1.7 \times 10^{18}$ | $1.8 \times 10^{18}$ | $1.9 \times 10^{18}$ |
| Example 15 (6 inches) | $1.6 \times 10^{18}$ | $1.8 \times 10^{18}$ | $2.0 \times 10^{18}$ |
| Comparative Example 13 (4 inches) | $1.9 \times 10^{18}$ | $1.8 \times 10^{18}$ | $1.9 \times 10^{18}$ |
| Comparative Example 15 (6 inches) | $2.0 \times 10^{18}$ | $1.8 \times 10^{18}$ | $2.0 \times 10^{18}$ |

[Discussion]

According to Table 6, the impurity atoms existing in the GaAs substrates of Example 13 and Example 15 uniformly increased in the direction from the wave source toward the center of the main surface, in other words, from the "wave source side" to the "ripple spreading side", and accordingly, the "ripple spreading side" showed a higher concentration distribution than the "wave source side". On the other hand, the impurity atoms existing in each of the GaAs substrates of Comparative Example 13 and Comparative Example 15 showed a distribution in which the concentration was equivalent on the "wave source side" and the "ripple spreading side".

The embodiments and the Examples of the present disclosure have been described as above, and it is also planned from the beginning to appropriately combine the configurations of the embodiments and the Examples described above.

The embodiments and the Examples disclosed herein should be considered in all respects illustrative and not restrictive. The scope of the present invention is defined not by the embodiments and the Examples mentioned above, but by the claims, and intended to encompass meanings equivalent to the claims, and all changes within the scope.

REFERENCE SIGNS LIST

O wave source; P ripple-like pattern; S main surface; 100 group III-V compound semiconductor single crystal substrate; 101 group III-V compound semiconductor single crystal substrate (conventional) ; I space; M measurement point; L1 virtual first straight line; L2 virtual second straight line; R1 first region; R2 second region; OF orientation flat; 1 crucible; 2 heating element; 3a interface; 31 seed crystal; 32 crystalline solid; 33 raw material melt; 3a interface; 4 crucible retaining table; 5 liquid sealing agent; S10 seed crystal charging step; S20 raw material charging step; S30 sealing agent arranging step; S40 crystal growth step; S50 cutting step and outer periphery grinding step.

**Claims**

**1.** A group III-V compound semiconductor single crystal substrate having a circular main surface, wherein

the group III-V compound semiconductor single crystal substrate is an indium phosphide single crystal substrate;
the indium phosphide single crystal substrate has a ripple-like pattern which is visually recognized on the main surface by being subjected to the following treatment:

the ripple-like pattern is a pattern corresponding to a part of ripples which concentrically spread from a wave source; and
the wave source is not positioned on the main surface, wherein
the treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 1 hour or more and 2 hours or less.

2. The group III-V compound semiconductor single crystal substrate according to claim 1, wherein a diameter of the indium phosphide single crystal substrate is 50 mm or more and 155 mm or less.

3. The group III-V compound semiconductor single crystal substrate according to claim 1 or claim 2, wherein a dislocation density of the main surface is 0 cm$^{-2}$ or more and 2000 cm$^{-2}$ or less.

4. The group III-V compound semiconductor single crystal substrate according to any one of claim 1 to claim 3, wherein

    a degree of asymmetry of dislocations existing in the main surface is 1.8 or more, wherein
    the degree of asymmetry is calculated by:

        dividing the main surface into a first region and a second region by a virtual first straight line which intersects perpendicularly with a virtual straight line extending in a direction from the wave source toward a center of the main surface, and passes through the center of the main surface;
        setting two or more square measurement points each having an area of 1 mm$^2$, at a pitch of 5 mm or more in a direction away from the center of the main surface, on a virtual second straight line which passes through the center of the main surface and intersects perpendicularly with the first straight line, in each of the first region and the second region, measuring the number of the dislocations at the measurement point, and also converting the number of the dislocations into a converted value per unit area of 1 cm$^2$ from the measurement result; and
        obtaining a numerical value by subtracting an average value of the converted values obtained from all the measurement points in the second region from an average value of the converted values obtained from all the measurement points in the first region, and dividing an absolute value thereof by an average value of the converted values which were obtained from all the measurement points in the first region and the second region.

5. A group III-V compound semiconductor single crystal substrate having a circular main surface, wherein

    the group III-V compound semiconductor single crystal substrate is a gallium arsenide single crystal substrate;
    the gallium arsenide single crystal substrate has a ripple-like pattern which is visually recognized on the main surface by being subjected to the following treatment:

        the ripple-like pattern is a pattern corresponding to a part of ripples which concentrically spread from a wave source; and
        the wave source is not positioned on the main surface, wherein
        the treatment horizontally arranges the main surface at a position of 10 mm below in a depth direction from a liquid level of a mixed liquid at 25°C, which contains 10 g of chromium(VI) oxide, 10 mL of a hydrofluoric acid solution having a concentration of 50% by mass, and 400 mL of pure water, and causes a reflection type incandescent electric lamp of 500 W to radiate light toward the main surface from a position which is spaced 20 cm upward from the liquid level, for 5 minutes or more and 20 minutes or less.

6. The group III-V compound semiconductor single crystal substrate according to claim 5, wherein a diameter of the gallium arsenide single crystal substrate is 75 mm or more and 205 mm or less.

7. The group III-V compound semiconductor single crystal substrate according to claim 5 or claim 6, wherein a dislocation density of the main surface is 0 cm$^{-2}$ or more and 50 cm$^{-2}$ or less.

8. The group III-V compound semiconductor single crystal substrate according to any one of claim 5 to claim 7, wherein

    a degree of asymmetry of dislocations existing in the main surface is 2.0 or more, wherein
    the degree of asymmetry is calculated by:

        dividing the main surface into a first region and a second region by a virtual first straight line which intersects perpendicularly with a virtual straight line extending in a direction from the wave source toward a center of the main surface, and passes through the center of the main surface;

setting two or more square measurement points each having an area of 1 mm$^2$, at a pitch of 5 mm or more in a direction away from the center of the main surface, on a virtual second straight line which passes through the center of the main surface and intersects perpendicularly with the first straight line, in each of the first region and the second region, measuring the number of the dislocations at the measurement point, and also converting the number of the dislocations into a converted value per unit area of 1 cm$^2$ from the measurement result; and

obtaining a numerical value by subtracting an average value of the converted values obtained from all the measurement points in the second region from an average value of the converted values obtained from all the measurement points in the first region, and dividing an absolute value thereof by an average value of the converted values which were obtained from all the measurement points in the first region and the second region.

9. The group III-V compound semiconductor single crystal substrate according to any one of claim 1 to claim 8, wherein the main surface is a plane having an off angle of 0° or more and 15° or less from a {100} plane.

10. The group III-V compound semiconductor single crystal substrate according to any one of claim 1 to claim 9, wherein an average value of a residual strain is $3.5 \times 10^{-5}$ or less, which is the absolute value of the difference between a stretching strain in a direction along a diameter of the main surface and a stretching strain in a direction along a tangent line.

11. The group III-V compound semiconductor single crystal substrate according to any one of claim 1 to claim 10, wherein in a polar coordinate that sets the center of the main surface as an origin point, and regards the virtual line segment as a starting line, which extends from the center of the main surface to a point 15 mm away from an outer periphery of the group III-V compound semiconductor single crystal substrate, along a direction from the center of the main surface toward the wave source, the residual strain which is the absolute value of the difference between the stretching strain in the direction along the diameter of the main surface and the stretching strain in the direction along the tangent line does not have such a distribution as to become an n-fold symmetry of which the center is set to the origin point, where n is an integer of 2 or more.

12. The group III-V compound semiconductor single crystal substrate according to any one of claim 1 to claim 11, wherein a conductivity type of the group III-V compound semiconductor single crystal substrate is an electron attracting type.

13. The group III-V compound semiconductor single crystal substrate according to any one of claim 1 to claim 12, wherein the group III-V compound semiconductor single crystal substrate contains tin or sulfur as an impurity atom, where the group III-V compound semiconductor single crystal substrate is the indium phosphide single crystal substrate, and contains silicon as an impurity atom, where the group III-V compound semiconductor single crystal substrate is the gallium arsenide single crystal substrate.

14. The group III-V compound semiconductor single crystal substrate according to claim 13, wherein an atomic concentration of the impurity atoms is $1 \times 10^{16}$ cm$^{-3}$ or more and $1 \times 10^{19}$ cm$^{-3}$ or less.

15. The group III-V compound semiconductor single crystal substrate according to claim 13 or claim 14, wherein the impurity atoms show such a concentration distribution as to uniformly change in a direction from the wave source toward the center of the main surface, in the group III-V compound semiconductor single crystal substrate.

16. A method for manufacturing a group III-V compound semiconductor single crystal substrate using a crystal growth apparatus, the method comprising:

obtaining a group III-V compound semiconductor single crystal, by bringing a seed crystal into contact with a raw material melt, and growing a crystalline solid on the raw material melt side of the seed crystal; and

obtaining a group III-V compound semiconductor single crystal substrate having a circular main surface, by cutting out the group III-V compound semiconductor single crystal, wherein

the crystal growth apparatus comprises at least a cylindrical crucible, and a heating element that heats the crucible;

the crucible houses the seed crystal at a bottom portion thereof, and houses the raw material melt above the seed crystal in the crucible; and

an interface between the crystalline solid and the raw material melt has a crossing angle of less than 90° with respect to an axis of the crucible.

FIG.1

P

S

O
X

100

FIG.2

P

O
X

S

101

FIG.3

FIG.4

FIG.5

FIG.6

FIG.7

FIG.8

S10 SEED CRYSTAL CHARGING STEP

S20 RAW MATERIAL CHARGING STEP

S30 SEALING AGENT ARRANGING STEP

S40 CRYSTAL GROWTH STEP (FIRST STEP)

S50 CUTTING STEP AND OUTER PERIPHERY GRINDING STEP (SECOND STEP)

## INTERNATIONAL SEARCH REPORT

| International application No. |
| --- |
| **PCT/JP2022/019084** |

### A. CLASSIFICATION OF SUBJECT MATTER

*C30B 29/40*(2006.01)i; *C30B 29/42*(2006.01)i
FI:   C30B29/40 A; C30B29/40 501Z; C30B29/42

According to International Patent Classification (IPC) or to both national classification and IPC

### B. FIELDS SEARCHED

Minimum documentation searched (classification system followed by classification symbols)

C30B1/00-35/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 62-265193 A (SUMITOMO ELECTRIC INDUSTRIES, LTD.) 18 November 1987 (1987-11-18) <br> claims 1, 2, p. 2, upper right column, line 8 to p. 2, lower left column, line 15, p. 3, lower left column, line 10 to p. 7, lower right column, line 11, fig. 1, 2 | 1-15 |
| A | | 16 |
| X | JP 7-10678 A (ASAHI GLASS CO., LTD.) 13 January 1995 (1995-01-13) <br> claims 1-5, paragraphs [0001]-[0008], [0016]-[0062], fig. 1 | 5-15 |
| A | JP 1-139223 A (SUMITOMO ELECTRIC INDUSTRIES, LTD.) 31 May 1989 (1989-05-31) <br> entire text | 1-16 |
| A | JP 2013-507313 A (AXT INC.) 04 March 2013 (2013-03-04) <br> entire text | 1-16 |
| A | JP 2016-117644 A (TOYOTA JIDOSHA KABUSHIKI KAISHA) 30 June 2016 (2016-06-30) <br> entire text | 1-16 |

☐ Further documents are listed in the continuation of Box C.　　☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
| --- | --- |
| **07 June 2022** | **21 June 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

**INTERNATIONAL SEARCH REPORT**
Information on patent family members

International application No.

**PCT/JP2022/019084**

| Patent document cited in search report | | | Publication date (day/month/year) | Patent family member(s) | | | Publication date (day/month/year) |
|---|---|---|---|---|---|---|---|
| JP | 62-265193 | A | 18 November 1987 | (Family: none) | | | |
| JP | 7-10678 | A | 13 January 1995 | (Family: none) | | | |
| JP | 1-139223 | A | 31 May 1989 | (Family: none) | | | |
| JP | 2013-507313 | A | 04 March 2013 | WO entire text EP | 2011/043777 2501844 | A1 A1 | |
| JP | 2016-117644 | A | 30 June 2016 | US entire text WO EP CN | 2015/0244021 2014/034794 2891731 104583469 | A1 A1 A1 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012236770 A
- WO 2004106597 A
- JP 2019043788 A

**Non-patent literature cited in the description**

- *Appl. Phys. Lett.*, 1985, vol. 47, 365-367